Europäisches Patentamt

European Patent Office

Office européen des brevets

(19)

(11)     EP 1 631 128 A1

(12)     **EUROPEAN PATENT APPLICATION**
published in accordance with Art. 158(3) EPC

(43) Date of publication:
    **01.03.2006   Bulletin 2006/09**

(51) Int Cl.:
    *H05H 1/24* (1974.07)          *H01L 21/3065* (1995.01)
    *H01L 21/205* (1974.07)

(21) Application number: **04732743.2**

(22) Date of filing: **13.05.2004**

(86) International application number:
    **PCT/JP2004/006434**

(87) International publication number:
    **WO 2004/103035 (25.11.2004 Gazette 2004/48)**

(84) Designated Contracting States:
    **DE FR GB**

(30) Priority: **14.05.2003   JP   2003136295**
    **04.02.2004   JP   2004028339**
    **17.03.2004   JP   2004077216**
    **17.03.2004   JP   2004077217**
    **12.05.2004   JP   2004142333**
    **12.05.2004   JP   2004142334**
    **12.05.2004   JP   2004142335**

(71) Applicant: **SEKISUI CHEMICAL CO., LTD.**
    **Osaka-shi,**
    **Osaka 530-8565 (JP)**

(72) Inventors:
    • **HINO, Mamoru**
      **Hachioji-city,**
      **Tokyo 192-0906 (JP)**

    • **MAYUMI, Satoshi,**
      **Hachioji-city,**
      **Tokyo 192-0906 (JP)**
    • **ITO, Takumi**
      **Kyoto-shi, Kyoto 601-8105 (JP)**
    • **UEHARA, Tsuyoshi**
      **Tsukuba-shi,**
      **Ibaraki 300-4247 (JP)**
    • **ONO, Takayuki**
      **Tsukuba-shi,**
      **Ibaraki 300-4247 (JP)**

(74) Representative: **Urner, Peter**
    **Patentanwälte**
    **TER MEER-MÜLLER-STEINMEISTER &**
    **PARTNER**
    **Mauerkircherstrasse 45**
    **D-81679 München (DE)**

(54)     **PLASMA PROCESSING APPARATUS AND METHOD FOR PRODUCING SAME**

(57)     A plasma processing apparatus is provided on the side to be directed to a workpiece W of electrodes 31, 32 with a conductive member 51 through an insulating member 41. The insulating member 41 is sandwiched between the electrodes 31, 32 and the conductive member 51. The dielectric constant and the thickness of the insulating member 41 are established such that the voltage applied to a gap 40b formed between the insulating member 41 and the conductive member 51 becomes smaller than the sparking voltage. Owing to this arrangement, electrical discharge can be prevented from occurring in the gap 40b and thus, the processing quality can be enhanced.

[Fig.1]

**Description**

[TECHNICAL FIELD]

This invention relates to an apparatus for performing a surface processing operation such as cleaning, film depositing, etching, surface modification and the like by plasmatizing a processing gas and jetting the plasmatized gas onto an object to be processed, i.e., workpiece and more particularly to a so-called remote type plasma processing apparatus in which a workpiece is arranged outside a plasmatizing space.

[BACKGROUND ART]

The plasma processing apparatus can be classified largely into two types; a so-called direct control type in which a workpiece is arranged in a plasmatizing space between electrodes and a so-called remote type in which a workpiece is arranged outside a plasmatizing space.

As one example of the remote type plasma processing apparatus, Patent Document 1 discloses an apparatus having a vertical planar configuration with a pair of electrodes arranged one on its right side and the other on its left side in an opposing relation. One of the electrodes is connected to a high frequency power source and serves as a voltage applying electrode and the other electrode is grounded and serves as a grounded electrode. A ceramic-made lower holder is disposed at the underside of the electrodes. The undersurface of this holder is faced with the workpiece. By applying an electric field coming from the power source to a space formed between the electrodes, the space is turned into a plasmatizing space. The processing gas is introduced into this space and plasmatized. The plasmatized gas is jetted downward and applied onto the workpiece. By doing so, the plasma surface processing of the workpiece can be carried out.

In the above-mentioned apparatus, the electrodes and thus, the plasmatizing space is obliged to be arranged away from the workpiece by at least a portion equal to the thickness of the ceramic-made lower holder. Because of this reason, the ratio of deactivating the processing gas until the processing gas reaches the workpiece is increased and the surface processing efficiency is not sufficient. Particularly, in case the processing is carried out under generally normal pressure (under pressure in the vicinity of atmospheric pressure), the deactivating ratio is further increased and the efficiency is further decreased. On the other hand, in case the lower holder is excessively thin, an arc discharge is liable to drop onto the workpiece when the electrodes are brought closer to the workpiece, with a result that inferior processing and damage of the workpiece tend to occur. Particularly, under generally normal pressure, an arc discharge is liable to drop. Moreover, there is such a fear that the workpiece is adversely affected by the electric field coming from the electrodes.

That is, in this kind of remote type plasma processing apparatus, in case the distance between the electrodes and the workpiece is short, an arc discharge is liable to drop onto the workpiece. In contrast, in case the distance is long, the plasma gas hardly reaches the workpiece and therefore, the processing efficiency is decreased. This tendency is significantly appeared to the plasma processing particularly under generally normal pressure.

In view of the above, the apparatus of Patent Document 2 is designed such that a metal plate is provided to the undersurface of at least the voltage applying electrode on the power source side through an insulating member. The metal plate is electrically grounded. This metal plate is faced with the workpiece. A lead-out path connected to the downstream of a plasmatizing space is formed in the insulating member. A jet port connected to the downstream of the lead-out path is formed in the metal plate. A plasmatizing space forming surface of the electrode, a lead-out path forming surface of the insulating member and a jet port edge surface of the metal plate are flush with one another. The plasmatizing space, the lead-out path and the jet port are straightly connected to each other, and the flow path section area is entirely uniform. The processing gas plasmatized in the plasmatizing space is jetted out through the jet port via the lead-out path. By doing so, arc discharge can be prevented from occurring to the workpiece. Moreover, since the plasmatizing space can be brought closer to the workpiece, the processing efficiency can be enhanced. Moreover, the electric field can be shielded between the electrodes and the workpiece by the metal plate, the electric field can be prevented from leaking to the workpiece and the workpiece can be prevented from being subjected to adverse effect of the electric field.

[Patent Document 1] Japanese Patent Application Laid-Open No. H09-92493
[Patent Document 2] Japanese Patent Application Laid-Open No. 2003-100646

[DISCLOSURE OF THE INVENTION]

[PROBLEM TO BE SOLVED BY THE INVENTION]

In the apparatus of the Patent Document 2, if there is a provision of an air layer such as a fine gap between the insulating member and the metal plate, there is such a fear that an electric discharge occurs there. Moreover, there is such a fear that the lead-out path forming surface of the insulating member, etc are broken by plasma. The result is that particles are generated and the processing quality may be degraded.

The plasmatizing space forming surface of the electrode, the lead-out path forming surface of the insulating member and the jet port edge surface of the metal plate are not necessarily flush with one another. Instead, those surfaces may be mutually protruded or withdrawn so that an electric discharge occurable from the electrodes and the insulating member can be prevented from occurring to the conductive member, etc. and the insulating member can be protected. In the alternative, sharpness of the processing gas flow can be adjusted to a desired level by varying the flow path section area.

The present invention has been made in view of the above-mentioned situation. It is, therefore, a main object of the present invention to prevent damage of an insulating body and discharge from occurring and to enhance the processing quality in a remote type plasma processing apparatus in which a conductive member is provided on the side to be directed to a workpiece of an electrode through an insulator.

[MEANS FOR SOLVING THE PROBLEM]

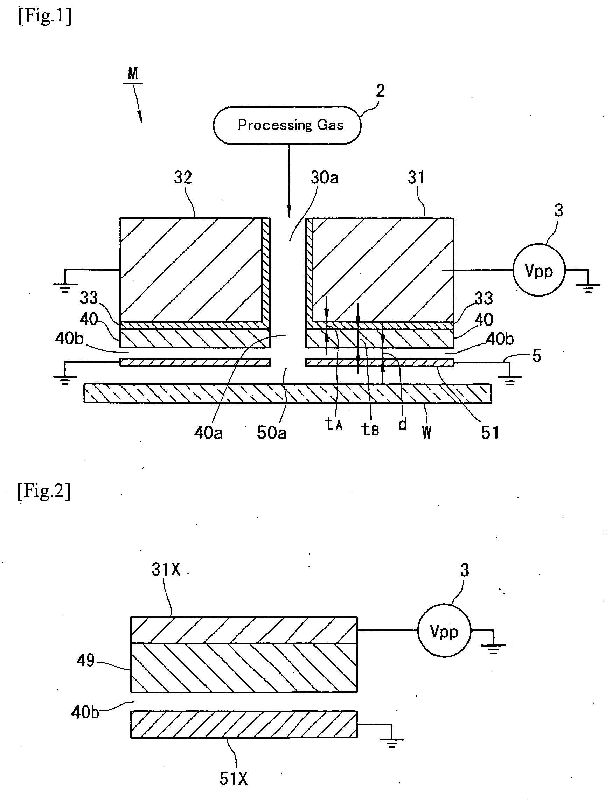

The first feature of the present invention resides in an apparatus for processing the surface of a workpiece, by jetting a plasmatized gas passed through a plasmatizing space (plasma generating space) onto a workpiece arranged outside the plasmatizing space, comprising an electrode for forming the plasmatizing space; a conductive member having electric field shielding and discharge preventing properties and arranged in such a manner as to shield the side of the electrode which is to be directed to the workpiece in a state that said conductive member is electrically gounded; and an insulating member composed of an insulator interposed between the electrode and the conductive member, the insulating member having such a dielectric constant and a thickness that the voltage between the insulating member and the conductive member does not reach the sparking voltage level i.e., not subjected to dielectric breakdown (see FIGS. 1 through 3). The feature also resides in that a gap is formed between the insulating member and the conductive member, and the dielectric constant and the thickness of the insulating member are established such that a voltage applied to this gap becomes smaller than the dielectric breakdown voltage so that the expression (2) as later described is satisfied. Owing to this arrangement, an electric discharge such as an arc (sparking) discharge can be prevented from occurring between the insulating member and the conductive member. Thus, the processing quality can be enhanced.

It is accepted that the electrode is provided at the plasmatizing space forming surface and the surface on the side to be directed to the plasmatizing space with a solid dielectric, and the insulating member is laid on the side of said workpiece of the solid dielectric (see FIG. 1). In that case, the dielectric constant and the thickness of the insulating member are determined by taking into consideration of the dielectric constant and the thickness on the workpiece side portion of the solid dielectric. The solid dielectric on the workpiece side and the insulating member may be integrally constructed. The solid dielectric on the workpiece side may be regarded as a part of the "insulating member".

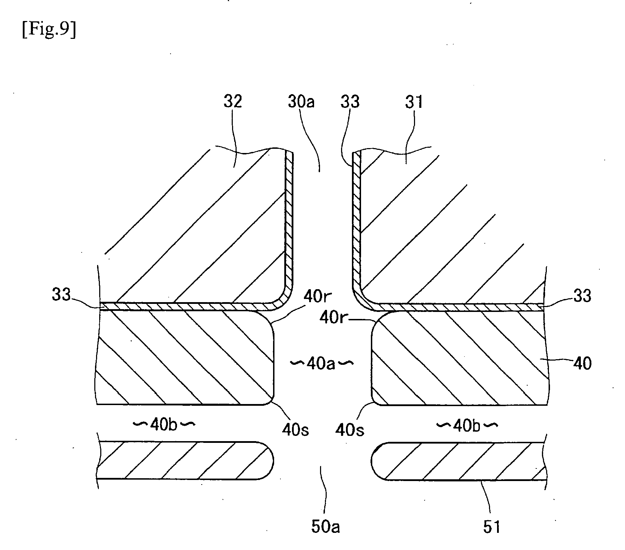

It is desirous that the insulating member includes a surface directed to the electrode, a surface for forming a processing gas lead-out path connected to the plasmatizing space, and a surface directed to the conductive member, a corner is formed between the surface directed to the electrode and the surface forming the lead-out path, and a corner is formed between the surface forming the lead-out path and the surface directed to the conductive member, and at least the former corner is chamfered (including round chamfering and square chamfering) (see FIG. 9, as well as elsewhere). By the former chamfering, the corner formed between the surface directed to the electrode and the lead-out path forming surface of the insulating member can be prevented from being broken by plasma and particles can be prevented from generating. By the latter chamfering, an electric discharge can reliably be prevented from occurring between the insulating member and the conductive member. In case two corners are to be chamfered, it is desirous that the corner formed between the surface directed to the electrode and the lead-out path forming surface is more headily chamfered than the corner formed between the lead-out path forming surface and the surface directed to the conductive member. The jet port edge surface of the conductive member is desirously located in the generally same position as the boundary between the surface directed to the conductive member and the lead-out path forming surface of the insulating member or in a position withdrawn therefrom. Owing to this arrangement, an electridc discharge can reliably be prevented from occurring between the insulating member and the conductive member.

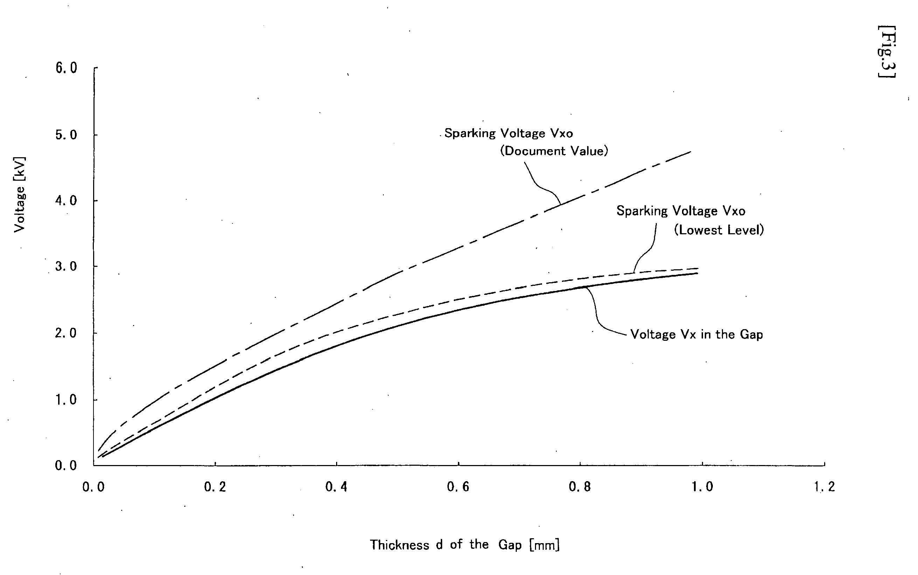

It is desirous that the dielectric constant and the thickness of the insulating member are established such that the voltage applied between the insulating member and the conductive member becomes smaller than the sparking voltage irrespective of the separation distance, i.e., the thickness of a gap formed between the insulating member and the conductive member. Owing to this arrangement, an electric discharge such as an arc discharge can reliably be prevented from occurring between the insulating member and the conductive member even if the separation distance, i.e., the thickness of the gap between the insulating member and the conductive member is varied. It is enough if the above-mentioned establishment is effective within a range in which the variation of the separation distance, i.e., thickness of the gap is expected to be occurred. It is desirous that even if the insulating member and the conductive member are so tightly attached to each other that no gap is formed therebetween, the dielectric constant and the thickness of the insulating member are established such that the voltage applied between the insulating member and the conductive member becomes smaller than the sparking voltage irrespective of the thickness d of the imaginary gap which is imagined as being formed between the insulating member and the conductive member. In case a gap having the thickness d is formed between the insulating member and the conductive member, even if the thickness d is somewhat increased or decreased, i.e., irrespective of variation of the thickness d, the dielectric constant and the thickness of the insulating member are desirously established such that the voltage applied between the insulating member and the conductive member becomes smaller than the sparking voltage (see FIG. 3).

It is desirous that an experiment(s) for measuring the sparking voltage is carried out and based on the measured data wherein a spark occurs at a lower level than the average, a relation of the sparking voltage is obtained with respect to the separation distance between the insulating member and the conductive member, i.e., the thickness of the gap formed between those two members. By doing so, an electric discharge such as an arc discharge can more reliably be prevented from occurring between the insulating member and the conductive member.

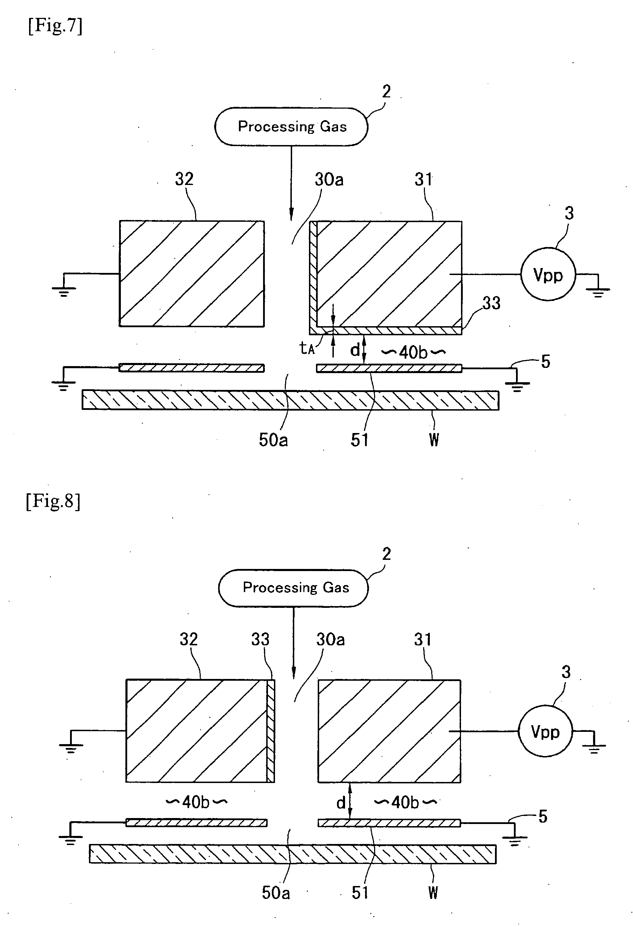

It is also accepted that the insulator interposed between the electrode and the conductive member is composed of a gas layer (hereinafter referred to as the "gas layer interposing construction" (see FIGS. 7 and 8)) instead of the insulating member and the thickness of this gas layer is established such that the voltage applied between the electrode and the conductive member becomes smaller than the sparking voltage. Owing to this arrangement, an electric discharge such as an arc (sparking) discharge can be prevented from occurring.

In the gas layer interposing construction, it is desirous that the solid dielectric is provided to the plasmatizing space forming surface and the surface on the side to be directed to the workpiece of the electrode (see FIG. 7), the gas layer is defined by the workpiece side solid dielectric and the conductive member, the thickness of the gas layer is established such that the voltage applied between the workpiece side solid dielectric and the conductive member becomes smaller than the sparking voltage.

At the time of manufacturing/designing the gas layer interposing construction, it is desirous that the thickness of the gas layer is established such that the voltage applied between the workpiece side solid dielectric and the conductive member becomes smaller than the sparking voltage irrespective of the separation distance between the electrode and the conductive member. Owing to this arrangement, an electric discharge such as an arc discharge can reliably be prevented from occurring even if the separation distance between the electrode and the conductive member is varied. It is enough if the above-mentioned establishment is effective within a range in which the variation of the separation distance is expected to be occurred.

At the time of designing/manufacturing the gas layer interposing construction, it is desirous that an experiment (s) for measuring the sparking voltage is carried out and based on the measured data wherein a spark occurs at a lower level than the average, a relation of the sparking voltage is obtained with respect to the thickness of the gas layer. By doing so, an electric discharge such as an arc discharge can more reliably be prevented from occurring between the electrode and the conductive member.

It is desirous that the conductive member includes a surface directed to the insulator, an edge surface for forming the jet port connected to the plasmatizing space and a surface to be directed to the workpiece, a corner is formed between the surface directed to the insulator and the jet port edge surface and a corner is formed between the jet port edge surface and the surface to be directed to the workpiece, and at least the former corner is chambered (including round chamfering and square chamfering). It is more desirous that the jet port edge surface is rounded toward the surface directed to the insulator and the surface to be directed to the workpiece (see FIG. 9, as well as elsewhere). Owing to this arrangement, an electric discharge can more reliably be prevented from occurring between the electrode and the conductive member or between the insulating member and the conductive member.

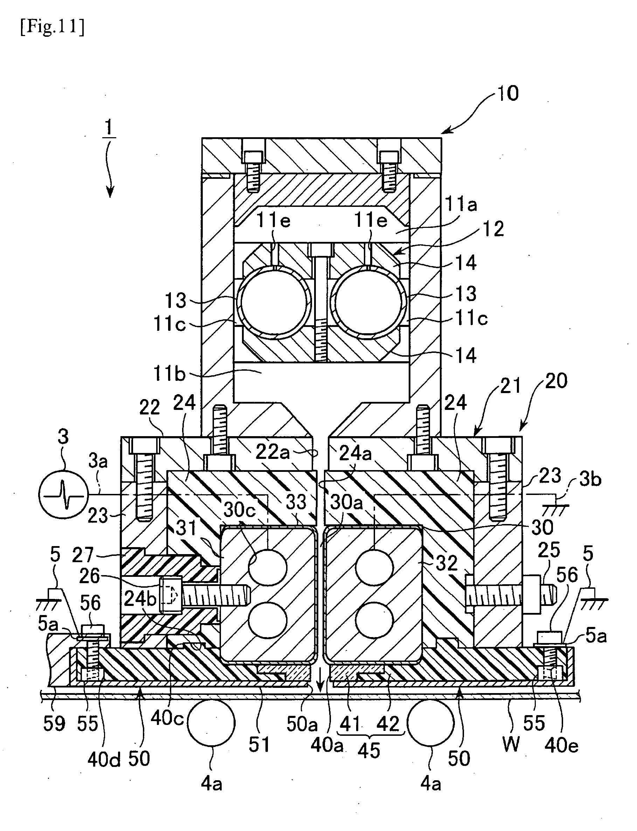

The second feature of the present invention resides in an apparatus for carrying out plasma processing by plasmatizing a processing gas and jetting the plasmatized gas onto a workpiece; the plasma processing apparatus comprising an electrode structure composed of a pair of electrodes for forming a plasmatizing space; a conductive member (discharge shielding plate, discharge shielding member) arranged in such a manner as to shield the side to be directed to the workpiece of the electrode structure in a state that the conductive member is electrically grounded; and an insulator interposed between the electrode structure and the conductive member, the insulator being divided into a first insulating part (first insulator) for forming a processing gas lead-out path (jet path) connected to the downstream of the plasmatizing space and a second insulating part (second insulator) separately arranged on the reverse side of the first insulating part lead-out path side (see FIG. 11, as well as elsewhere).

Owing to the above-mentioned arrangement, when the first insulating part of the insulator is broken by plasma, only the damaged insulating part may be replaced and the entire insulator is not required to be replaced. Moreover, only the first insulating part may be composed of a plasma resistance material and the entire insulator is not required to be composed of a plasma resistance material. As a result, the material cost can be reduced. The conductive member and the insulator (at least the first insulating part) may be contacted with each other. By doing so, electric charge can be prevented from being accumulated on the insulator.

The first insulating part is desirously composed of an insulating material having a plasma resistance property. The first insulating part is desirously composed of an insulating material having a higher plasma resistance property than the second insulating part. Owing to this arrangement, the lead-out path forming surface of the insulator can be prevented from being damaged by the plasmatized processing gas. Thus, particles can be prevented from generating and the processing quality can be enhanced. With respect to such a part, i.e., second insulating part, as being not exposed to plasma, it is not necessary to provide a plasma resistance property and therefore, it can be composed of a comparatively inexpensive material. Thus, the insulator can be reduced in its material cost rather than composing the entire insulator with a material having a high plasma resistance property.

As an insulating material having a high plasma resistance property, there can be listed, for example, quartz, alumina, aluminum nitride and the like.

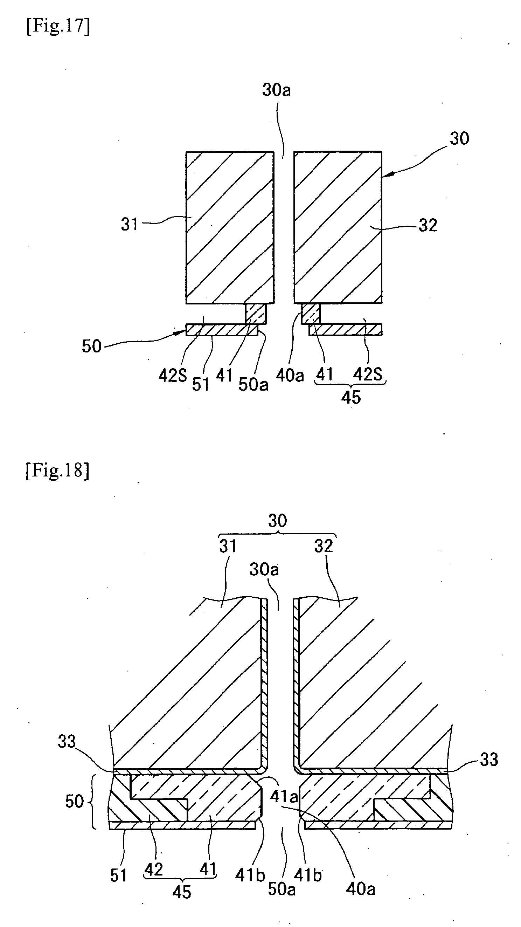

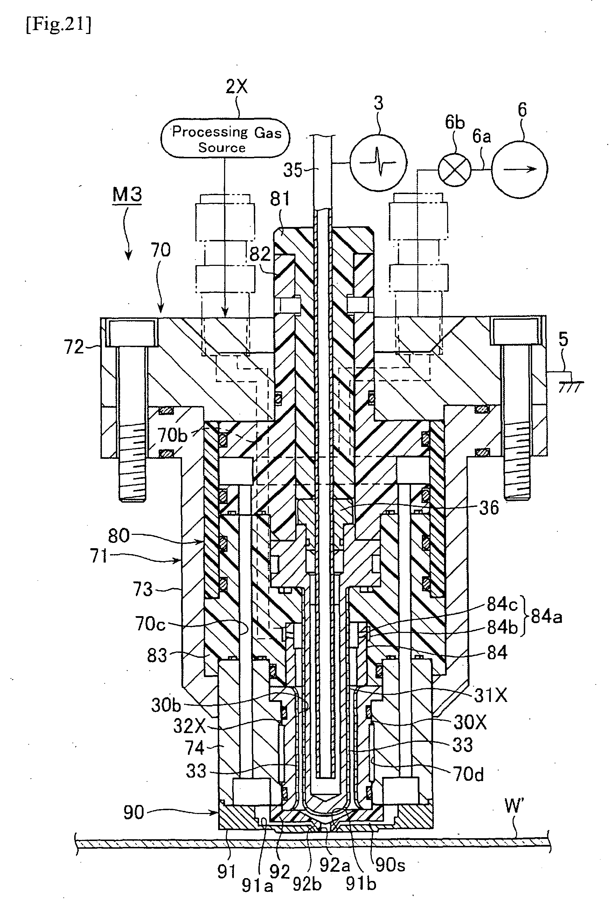

The second insulating part may be composed of a gas layer such as air (see FIGS. 17 and 21). Since the gas such as air has a good dielectric strength, the gap formed between the electrode structure and the conductive member can reliably be insulated. Moreover, the material cost of the insulator can further be reduced.

It is desirous that the electrode structure comprises an electric field applying electrode connected to an electric field applying means (power source) and a grounding electrode electrically grounded, and the insulator and the conductive member are arranged in such a manner as to correspond to at least the electric field applying electrode of all the electrodes. Owing to this arrangement, an arc discharge and an electric field can reliably be prevented from leaking to the workpiece.

The lead-out path forming surface of the first insulating part is desirously withdrawn from the plasmatizing space forming surface of the electrode structure (see FIG. 11, as well as elsewhere). Owing to this arrangement, the first insulating member can more reliably be prevented from being damaged.

It is also accepted that the conductive member includes an edge surface for forming the jet port connected to the downstream of the lead-out path, and this jet port edge surface is withdrawn from the plasmatizing space forming surface or the lead-out path forming surface of the first insulating part of the electrode structure (see FIG. 11, as well as elsewhere). Owing to this arrangement, an electric discharge can be prevented from occurring between the electrode and the jet port edge surface of the conductive member.

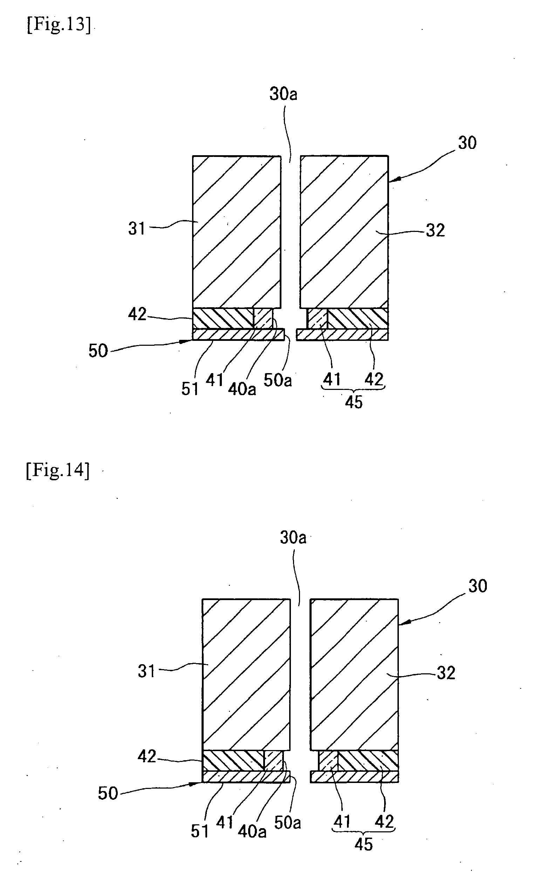

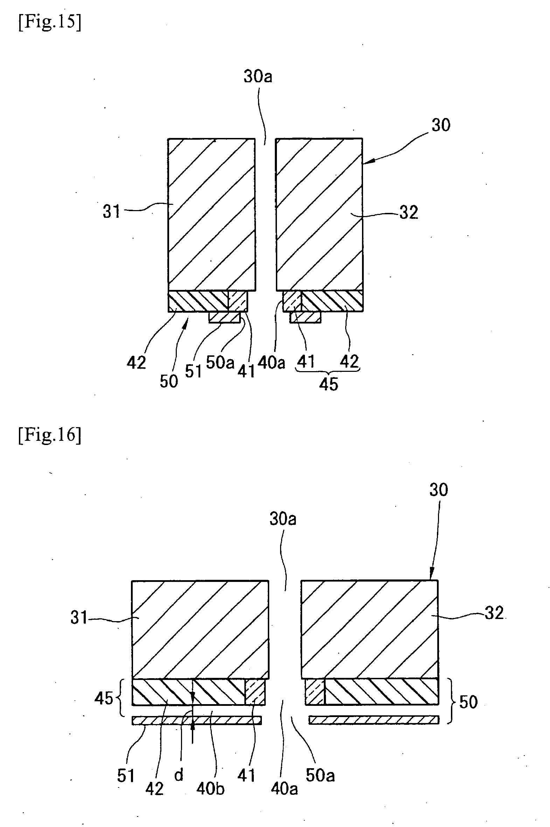

The jet port edge surface of the conductive member may be protruded from the plasmatizing space forming surface of the electrode structure (see FIG. 13, as well as elsewhere), or it may be protruded from the lead-out path forming surface of the first insulating part (see FIG. 13, as well as elsewhere). Owing to this arrangement, the processing gas flow can be sharpened by being reduced at the jet port and the processing efficiency can be enhanced. The outer surface (rear surface) on the reverse side of the jet port of the conductive member may be flush with the outer surface (rear surface) on the reverse side of the plasmatizing space in the electrode (see FIG. 13, as well as elsewhere), it may be withdrawn inward (jet port side) from the outer surface of the electrode (see FIG. 15), or it may be protruded outward from the outer surface of the electrode (see FIG. 11, as well as elsewhere).

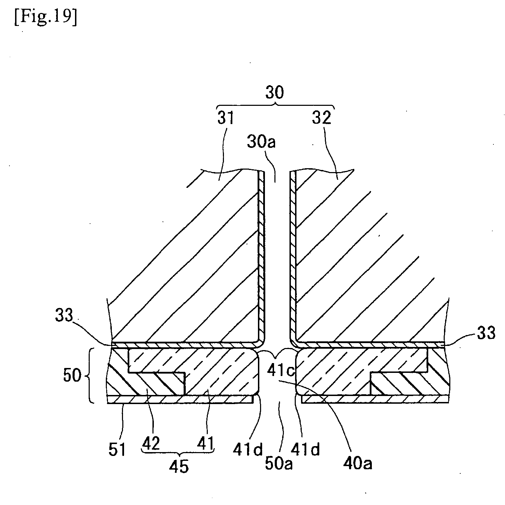

It is desirous that the corner formed between the surface directed to the electrode structure and the lead-out path forming surface of the first insulating part is chamfered (including round chamfering (FIG. 19) and square chamfering (FIG. 18), thereby forming a first chamfered part (see FIGS. 18 through 20, as well as elsewhere). Owing to this arrangement, the corner formed between the surface directed to the electrode structure and the lead-out path forming surface of the first insulating part can be prevented from being broken by plasma and particles can be prevented from generating.

It is also accepted that the corner formed between the lead-out path forming surface and the surface directed to the conductive surface of the first insulating part is chamfered (including round chamfering (FIG. 19) and square chamfering (FIG. 18)), thereby forming a second chamfered part (see FIGS. 18 through 20, as well as elsewhere). Owing to this arrangement, an electric discharge can be prevented from occurring between the first insulating part and the conductive member.

From a viewpoint that the prevention of breakage of the corner formed between the surface directed to the electrode structure and the lead-out path forming surface of the first insulating part should be carried out prior to the prevention of an electric discharge occurred between the first insulating part and the conductive member, the first chamfered part is desirously more heavily chamfered than the second chamfered part (see FIGS. 18 through 20, as well as elsewhere).

It is desirous that the jet port edge surface of the conductive member is located in the generally same position as the boundary between the surface directed to the conductive member and the second chamfered part of the first insulating part or in a position withdrawn therefrom (see FIGS. 18 and 19, as well as elsewhere). Owing to this arrangement, an electric discharge can be prevented from occurring between the first insulating part and the conductive member.

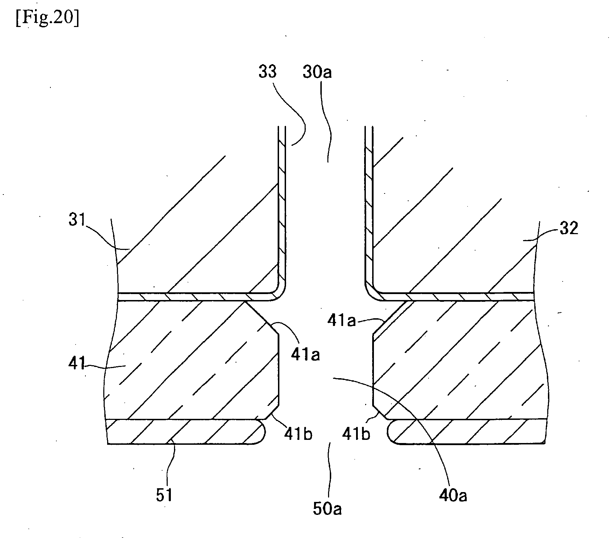

The corner formed between the jet port edge surface and the surface directed to the conductor of the conductive member is desirously chamfered (including round chamfering and square chamfering) and more preferably, the corner formed between the jet port edge surface and the surface directed to the workpiece and on the reverse side of the surface directed to the insulator directed to the workpiece is chamfered (including round chamfering and square chamfering). Also, the jet port edge surface is more desirously rounded toward the surface directed to the insulator and the surface directed to the workpiece (see FIG. 20). Owing to this arrangement, an electric discharge can be prevented from occurring between the electrode and the conductive member or between the first insulating part and the conductive member.

In the second feature, it is accepted that a hole part is opened in the conductive member, the processing gas lead-out path of the first insulating part is arranged inside the hole part, a suction path serving the hole part as a suction port is defmed by the conductive member and the first insulating part, and this suction path is provided as a gas layer serving as the second insulating part (see FIG. 21). This makes it possible not only to insulate the electrode and the conductive member but also to suck and exhaust the processed gas. It is also accepted that one of the electrodes of the electrode structure is coaxially and annularly surrounded with the other electrode, thereby forming the plasmatizing space into an annular configuration. The lead-out path of the first member may be connected to the entire periphery of the annular plasmatizing space.

The third feature of the present invention resides in that the plasmatizing space forming surface of the electrode, the lead-out path forming surface of the insulating member and the jet port edge surface of the conductive member are mutually protruded or withdrawn (see FIGS. 11,13 and 14, as well as elsewhere).

According to one embodiment of the third feature, there is provided an apparatus for carrying out plasma processing by plasmatizing a processing gas and jetting the plasmatized gas onto a workpiece, the plasma processing apparatus comprising an electrode structure composed of a pair of electrodes for forming a plasmatizing space; and a conductive member arranged on the side to be directed to the workpiece (jet-out side) of the electrode structure through an insulator in a state that the conductive member is electrically grounded, the conductive member including an edge surface for forming a jet port connected to the downstream of the plasmatizing space, the jet port edge surface being non-flush with the plasmatizing space forming surface of the electrode. That is, the jet port edge surface of the conductive member may be withdrawn from the plasmatizing space forming surface of the electrode (see FIG. 11, as well as elsewhere) or it may be protruded therefrom (see FIG. 13). In case the jet port edge surface is withdrawn, an electric discharge from the electrode to the jet port edge part of the conductive member can be prevented from occurring. In case the jet port edge surface is protruded, the processing gas can be jetted out sharply and the processing efficiency can be enhanced.

In some instance, the plasmatizing space forming surface of the electrode is provided with a solid dielectric layer. In that instance, the jet port edge surface of the conductive member may be protruded from the front surface of the solid dielectric instead of being merely stayed on the plasmatizing space forming surface of the electrode. The insulator may be comprised of an insulating member composed of a solid insulating member, it may be comprised of a gas layer such as air, or it may be composed of both the insulating member and the insulating member (see FIGS. 16 and 17). It is preferable that the insulating member includes a surface for forming a lead-out path (jet path) connected to the downstream of the plasmatizing space and connected to the upstream of the jet port. The insulating material of the part forming the lead-out path desirously has a plasma resistance property. If the conductive member and the insulating member are contacted with each other, electric charge can be prevented from being accumulated on the insulator. The gas layer may be provided on the reverse side of the lead-out path side of the insulating member.

According to another embodiment of the third feature, there is provided an apparatus for carrying out plasma processing by plasmatizing a processing gas and jetting the plasmatized gas onto a workpiece, the plasma processing apparatus comprising an electrode structure composed of a pair of electrodes for forming the plasmatizing space; and a conductive member arranged on the side (jet side) to be directed to the workpiece of the electrode structure through an insulator including a solid insulating member in a state that the conductive member is electrically grounded, the insulating member including a surface for forming a lead-out path (jet path) connected to the downstream of the plasmatizing space, the conductive member including an edge surface for forming a jet port connected to the downstream of the lead-out path, and the jet port edge surface being non-flush with the lead-out path forming surface of the insulating member. That is, the jet port edge surface of the conductive member may be withdrawn from the lead-out path forming surface of the insulating member (see FIG. 11, as well as elsewhere), or it may be protruded therefrom (see FIG. 13). In case the jet port edge surface is withdrawn, an electric discharge from the electrode to the jet port of the conductive member can more reliably be prevented from occurring. In case the jet port edge surface is protruded, the jetting speed of the processing gas can be increased and the processing efficiency can further be enhanced. The insulator may include not only the solid insulating member but also a gas layer such as air.

In the third feature, the lead-out path forming surface of the insulating member is desirously withdrawn from the plasmatizing space forming surface of the electrode (see FIGS. 11 and 13, as well as elsewhere). Owing to this arrangement, the insulating member can be prevented from being broken by plasma. At least the lead-out path forming surface in the insulating member desirously has a plasma resistance property. Owing to this arrangement, damage can more effectively be prevented from occurring.

In the third feature, the outer surface (rear surface) on the reverse side of the jet port of the conductive member may be flush with the outer surface (rear surface) on the reverse side of the plasmatizing space in the electrode (see FIG. 13, as well as elsewhere), it may be located in a position withdrawn inward (jet port side) of the outer surface of the electrode (see FIG. 15), or it may be protruded outward of the outer surface of the electrode (see FIG. 11).

In the third feature, it is desirous that the corner formed between the surface directed to the electrode structure and the lead-out path forming surface of the insulating member is chamfered (including round-chamfering (FIG. 19)) and square chamfering (FIGS. 18 and 19)), thereby forming the first chamfered part (see FIGS. 18 through 20). Owing to this arrangement, the corner formed between the surface directed to the electrode structure and the lead-out path forming surface of the insulating member can be prevented from being broken by plasma, and particles can be prevented from generating.

In the third feature, it is also accepted that the corner formed between the lead-out path forming surface and the surface directed to the conductive member of the insulating member is chamfered (including round chamfering (FIG. 19) and square chamfering (FIGS. 19 and 20)), thereby forming the second chamfered part (see FIGS. 18 through 20). Owing to this arrangement, an electric discharge can be prevented from occurring between the insulating member and the conductive member.

In the third feature, from a viewpoint that the prevention of breakage of the corner formed between the surface directed to the electrode structure and the lead-out path forming surface of the insulating member should be carried out prior to the prevention of an electric discharge occurred between the insulating member and the conductive member, the first chamfered part is desirously more heavily chamfered than the second chamfered part (see FIGS. 18 through 20).

In the third feature, it is desirous that the jet port edge surface of the conductive member is located in the generally same position as the boundary between the surface directed to the conductive member and the second chamfered part of the insulating member or in a position withdrawn therefrom (see FIGS. 18 and 19). Owing to this arrangement, an electric discharge can be prevented from occurring between the insulating member and the conductive member.

In the third feature, the corner formed between the jet port edge surface and the surface directed to the conductor of the conductive member is desirously chamfered (including round chamfering and square chamfering). More preferably, the corner formed between the jet port edge surface and the surface to be directed to the workpiece and on the reverse side of the surface directed to the insulator is chamfered (including round chamfering and square chamfering). Also, the jet port edge surface is more desirously rounded toward the surface directed to the insulator and the surface to be directed to the workpiece (see FIG. 20). Owing to this arrangement, an electric discharge can be prevented from occurring between the electrode and the conductive member and between the insulating member and the conductive member.

In the third feature, it is accepted that the electrode structure comprises an electric field applying electrode connected to the electric field applying means and an grounding electrode electrically grounded, and the conductive member is provided in such a manner as to correspond to at least the electric field applying electrode of all the electrodes. Owing to this arrangement, an electric discharge and leakage of an electric field can reliably be prevented from occurring to the workpiece.

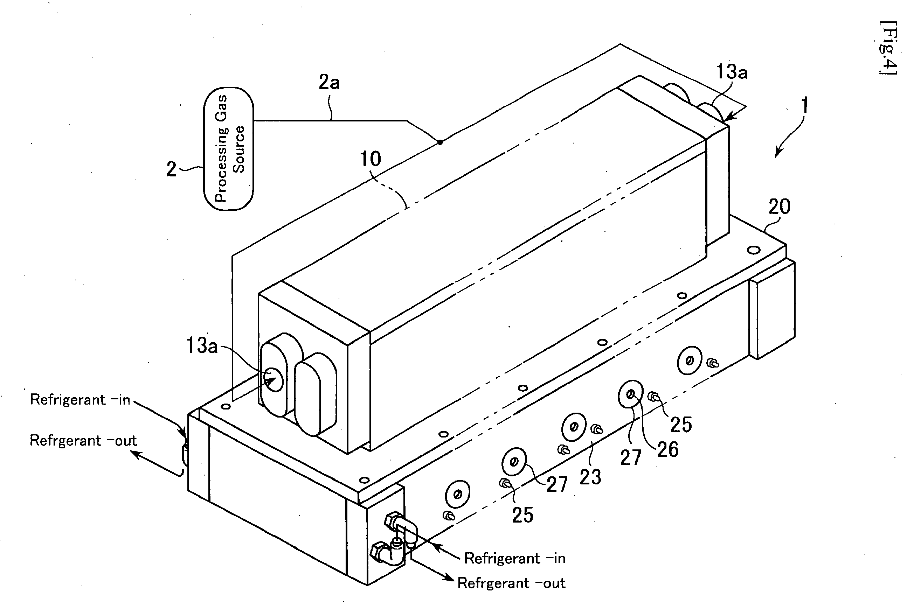

In the present invention, it is accepted that the pair of electrodes of the electrode structure has an elongate configuration extending in the direction orthogonal to the mutually opposing direction, the insulator and the conductive member are extended in the same direction as the electrodes and thus, the lead-out path and a jet port formed in the conductive member in such a manner as to be connected to the downstream end of the lead-out path are extended in the same direction as the electrodes, the jet port being open in the direction generally orthogonal to the mutually opposing direction and the extended direction (see FIGS. 4 through 6, as well as elsewhere). In other words, it is also accepted that the pair of electrodes are each extended in the direction generally orthogonal to the mutually opposing direction and the jet axis, the conductive member is extended in the same direction as the electrodes, and the jetting direction of the processing gas is directed in the direction generally orthogonal to the mutually opposing direction and the extended direction. Owing to this arrangement, the jet port can be elongated and the surface processing equivalent to this length portion can be carried out at a time.

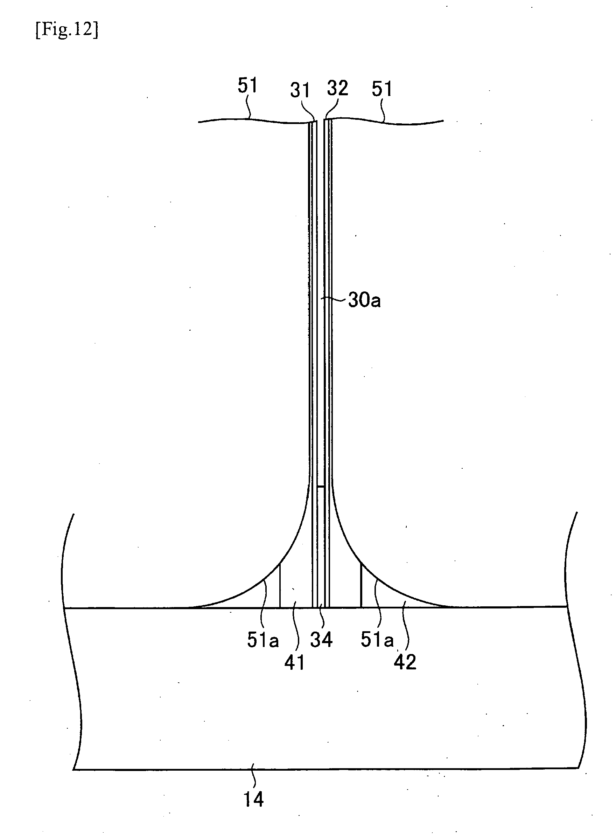

In the elongated structure, it is desirous that a spacer composed of an insulating material is sandwiched between the respective end parts on the same side in the longitudinal direction of the pair of electrodes, and the conductive member is formed in such a manner as to keep away from the boundary between the spacer and the electrodes (see FIG. 12). Owing to this arrangement, when a surface discharge occurs at the boundary between the spacer and the electrode, the surface discharge can be prevented from conducting to the conductive member.

In the present invention, the electrode can be brought closer to the workpiece while preventing an arc discharge from occurring to the workpiece. Accordingly, processing inferiority and damage of the workpiece can reliably be prevented from occurring, and the plasmatized processing gas can reliably be applied to the workpiece before the processing gas is deactivated. Thus, the plasma surface processing efficiency can be enhanced. Particularly, this advantage is great when the surface processing is carried out under generally normal pressure. Moreover, an electric field can be prevented from leaking to the workpiece and the workpiece can be kept free from adverse effect of the electric field. In case the conductive member and the insulating member are contacted with each other, an electric field can be prevented from being accumulated on the insulating member.

The term "generally normal pressure (pressure in the vicinity of atmospheric pressure)" used herein refers to a pressure ranging from $1.013 \times 10^4$ to $50.663 \times 10^4$ Pa, preferably from $1.333 \times 10^4$ to $10.664 \times 10^4$ Pa and more preferably from $9.331 \times 10^4$ to $10.397 \times 10^4$ Pa when taking into consideration of easiness of pressure adjustment and simplification of apparatus construction.

[BEST MODE FOR CARRYING OUT THE INVENTION]

Embodiments of the present invention will be described hereinafter with reference to the drawings.
A first embodiment will be described. FIG. 1 is a view schematically showing the construction of a normal pressure plasma processing apparatus. The normal pressure plasma processing apparatus M includes a pair of mutually opposing electrodes 31, 32. The electrode 31 is connected with a power source 3 as a voltage applying means and the remaining electrode 32 is grounded. Formed between the electrodes 31, 32 is a plasma generating space 30a. An electric field is applied to the plasma generating space 30a by the power source 3, thereby occurring a glow discharge. A processing gas fed from a processing gas source 2 is introduced into the plasma generating space 30a and plasmatized. The processing gas thus plasmatized is sprayed onto a workpiece W or an object to be processed located thereunder, through a jet port 40b as later described. By doing so, the workpiece W is subjected to surface processing. This surface processing operation is carried out under normal pressure.

A solid dielectric for preventing the arc discharge from occurring in the space 30a is deposited, in the form of a thin film, on the opposing surfaces and the undersurfaces of the respective electrodes 31, 32 by thermal spraying. The thickness of the solid dielectric 33 is shown in an exaggerated manner.

The electrodes 31, 32 are provided at the undersurface side (workpiece side) with an insulating member 40 composed of a solid insulator. A processing gas lead-out path 40a connected to the downstream side of the plasma generating space 30a is formed at the central part of the insulating member 40.

The insulating member 40 is provided at the underside with a conductive member 51 composed of a metal plate. A jet port 50a connected to the downstream side of the lead-out path 40a is formed in the central part of the conductive member 51. The conductive member 51 is electrically grounded through an earthing wire 5. The conductive member 51 is arranged on the jetting-out side of the processing gas of the electrodes 31, 32 in order to prevent an electrode structure 30 from being directly faced with the workpiece W. The undersurface of the conductive member 51 on the opposite side of the electrodes 31, 32 is directly faced with the workpiece W to be processed.

Owing to the above-mentioned arrangement, the arc discharge can be prevented from dropping onto the workpiece W from the electrode 31 and the plasma gas can reliably be reached to the workpiece W by bringing the jet port 50a closer to the workpiece W. Thus, the processing efficiency can be enhanced. Moreover, the electric field can be prevented from leaking to the workpiece W, so that the workpiece W can be kept free from the adverse effect of the electric field. The conductive member 51 constitutes a discharge preventive member for preventing the occurrence of discharge such as arc discharge or an electric field shielding member for shielding the electric field from the electrode 31. The conductive member 51 may be provided to the underside of at least the voltage applying electrode 31 of all the electrodes 31, 32.

A gap 40b is formed between the insulating member 40 and the conductive member 51. Air is flowed into the gap 40b under normal pressure. The gap 40b may be positively formed in order to enhance the insulating property or the gap 40b may be accidentally formed by some reason. For example, even when the insulating member 40 and the conductive member 51, which are separately made, are merely superposed each other, a gap is formed in some instance.

The voltage Vx applicable to the gap 40b can be expressed by the following expression.

$$Vx = \varepsilon_A \varepsilon_B V_{pp}\, d\, /\, 2\, (\, \varepsilon_A t_B +\, \varepsilon_B t_A +\, \varepsilon_A\, \varepsilon_B d) \qquad\qquad (1)$$

wherein
d: thickness of the gap 40b, i.e., separation distance between the insulating member 40 and the conductive member 51,
$V_{pp}$: peak-to-peak voltage of the electrode 31
$\varepsilon_A$ : relative dielectric constant of the solid dielectric 33
$\varepsilon_B$ : relative dielectric constant of the insulating member 40
$t_A$ : thickness of the underside part of the electrode of the solid dielectric 33
$t_B$ : thickness of the insulating member 40
The gap 40b, i.e., the relative dielectric constant of air is preliminarily set to "1".

The peak-to-peak voltage $_{pp}$ is established to a value in a range of, for example, several kV to several tens kV. The thickness $t_A$ of the underside part of the electrode of the solid dielectric 33 is equal to the thickness of the side part of the plasma generating space 30a. The relative dielectric constant $\varepsilon_A$ (i.e., material quality) and the thickness $t_A$ of the solid dielectric constant 33 are set such that a favorable glow discharge can be maintained.

The relative dielectric constant $t_B$ and the thickness $t_B$ of the insulating member 40 of the plasma processing apparatus M is set so as not to allow air in the gap 40b to cause insulation breakage by taking into consideration of the

above-mentioned $V_{pp}$, $\varepsilon_A$ and $t_A$. That is, if the sparking voltage (insulation breakage voltage) in the gap 40b is represented by Vxo, the relative dielectric constant $\varepsilon_B$ and the thickness $t_B$ are set such that the following expression can be satisfied.

$$\text{Vxo} > \text{Vx} = \varepsilon_A \varepsilon_B V_{pp} d / 2 \, (\varepsilon_A t_B + \varepsilon_B t_A + \varepsilon_A \varepsilon_B d) \qquad (2)$$

Owing to the above-mentioned arrangement, arc discharge can be prevented from being formed in the gap 40b. Hence, the insulating member 40 can be prevented from being baked so as not to generate particles and as a result, the processing quality can be enhanced and the yield of production can be enhanced, too.

Incidentally, the relative dielectric constant $\varepsilon_B$ of the insulating member 40 is determined by its material quality. The relative dielectric constant $\varepsilon_B$ of alumina is about 7.5; alkali glass, about 6 to 9; pyrex (registered trademark) glass, about 4.5 to 5.0; quartz glass, about 3.5 to 4.5; and vinyl chloride, about 3.0 to 3.5, respectively. It is, therefore, desirable that after the material quality is determined, the thickness $t_B$ is established in accordance with its relative dielectric constant $\varepsilon_B$.

The sparking voltage Vxo in the gap 40b can be obtained by using the following expression (3) of the known document.

$$\text{Vxo} = 2.405 \, \delta d \, (1 + 0.328 \, ( \, \delta d / 10 \, ^{-1/2} ) \qquad (3)$$

[Document: DENKIGAKKAI DAIGAKUKOZA,
DENRIKITAIRON, p116,
Issued by Ohmusha]
In the expression (3), the unit of sparking voltage Vxo is "kV", and the unit of the thickness d of the gap 40b is "mm" (the same is applicable to the expression (5)). $\delta$ represents the relative air density. If the temperature in the gap 40b is represented by T degrees C and the pressure, by P (mmHg), respectively, the following expression (4) can be obtained.

$$\delta = 0.386P / (273 + T) \qquad (4)$$

For example, under the conditions of 20 degrees C and 760 mmHg, $\delta$ = 1.00122867 is obtained. If the expression (3) at that time, in other words, if the sparking voltage Vxo (the document value) vs. the thickness d of the gap 40d is shown in a graph, it becomes as indicated by the one-dot chain line of FIG. 3.

However, the above-mentioned document expression 3 shows an average and actually, it can sometimes happen that the sparking occurs at a lower voltage than that. Therefore, the inventors attempted to newly formulate the sparking voltage Vxo into an expression through experiment(s). That is, as shown in FIG. 2, glasses 49 having the same relative dielectric constant (relative dielectric constant = 4.4) but different thicknesses were, one by one, attached to the undersurface of an electrode plate 31X on the voltage applying side corresponding to the electrode 31, and the peak-to-peak voltage $V_{pp}$ was checked at the time the sparking discharge occurred in the gap 40b between each glass 49 and the grounding metal plate 51X corresponding to the conductive member located under the glass 49. The thickness of the gap 40b was set to d = 0.5 mm. The glass 49 herein used corresponds to the solid dielectric 33 and the insulating member 40 of the plasma processing apparatus. Therefore, the thickness of the glass 49 corresponds to $t_A + t_B$. Also, $\varepsilon_A = \varepsilon_B = 4.4$.

As a result, the largest irregularity in the minus direction with respect to the above-mentioned document value of the expression (3) occurred when the thickness ($t_A + t_B$) was 2.9 mm. At that time, the peak-to-peak voltage was 11.4 kV (i.e., $V_{pp}$ = 11.4kV). By substituting this result for the right side of the expression (1), the following expression of the sparking voltage Vxo with respect to the thickness d of the gap 40b was obtained.

$$\text{Vox} = 8.65d / (1.52d + 1) \qquad (5)$$

This expression (5) shows the sparking voltage Vxo at the lowest level for spark to occur with respect to the thickness d of the gap 40b. If the expression (5) is shown in the form of a graph, it becomes as indicated by the broken line of FIG.

3. As a matter of course, this broken line is located lower than the one-dot chain line of the document expression (3).

In manufacture of the plasma processing apparatus M, at the time of establishing the relative dielectric constant $\varepsilon_B$ and the thickness $t_B$ of the insulating member 40, the expression (5), i.e., the sparking voltage Vxo at the lowest level is used as a reference and it is judged whether or not the voltage Vx in the gap 40b is smaller than the sparking voltage Vxo, that is, whether or not the expression (2) is satisfied. By doing so, an electric discharge such as an arc discharge can more reliably be prevented from occurring in the gap 40b.

As shown in FIG. 3, the curved line (solid line of FIG. 3) indicating the voltage Vx expressed by the expression (1) is entirely (or partly in the range which d can take) lower than the broken line indicating the sparking voltage at the lowest level of the expression (5) on the graph. The lowest limit is preferably that the value of the voltage Vx with respect to the thickness d becomes, for example, 0.8 to 0.9 times the value of the sparking electrode Vxo in the same thickness d. Owing to this arrangement, an electric discharge such as an arc discharge can be prevented from occurring in the gap 40b irrespective of the thickness of the gap 40b. This is particularly effective in such a case where the gap 40b is accidentally formed by one or other causes and the thickness d of the gap 40b is difficult to anticipate.

The solid line of FIG. 3 is subjected to the following conditions.

material of solid dielectric 33: alumina ($\varepsilon_A$ = 7.5), thickness: $t_A$ = 0.5 mm

material of insulating member 40: alkari glass ($\varepsilon_B$ = 7.0), thickness: $t_B$ = 6.2 mm

interpeak voltage: $V_{pp}$ = 13 kV

Of course, in case the thickness d is known when the gap 40d is positively formed, it is good enough if the expression (2) is satisfied in this particular thickness d. Referring back to the graph of FIG. 3, it is good enough if the voltage Vx line is located lower than the lowest level sparking voltage Vxo line at least at this particular thickness d spot (or its vicinity).

It is desirous that a spreadsheet software with a graph preparing function which can be executed by a calculating machine such as a personal computer is preliminarily obtained and the above-mentioned expressions (1) and (5) are preliminarily stored in this machine so that a graph as in FIG. 3 can readily be drawn using $\varepsilon_A$, $\varepsilon_B$, $t_A$, $t_B$, etc. as parameters. Owing to this arrangement, the above-mentioned judgment can easily be made.

It is also accepted that instead of the lowest level sparking voltage Vxo (expression (5)), the relative dielectric constant $\varepsilon_B$ and the thickness $t_B$ of the insulating member 40 are obtained based on the average sparking voltage Vx (document expression (3)).

FIGS. 4 through 6 show one embodiment of a specific structure of a normal pressure plasma processing apparatus.

This plasma processing apparatus M1 comprises a workpiece feed mechanism 4, a plasma nozzle head 1 supported on a mount table (not shown) in such a manner as to be located above the feed mechanism 4, and a processing gas source 2 and a power source 3 which are connected to this nozzle head 1.

Processing gases in accordance with requirements of various kinds of processing are reserved in the processing gas source 2. For example, as processing gases for plasma cleaning, a pure gas of $N_2$ or a mixed gas of $N_2$ and a fine amount of $O_2$ is reserved there. Those gases may be reserved in the liquid state so that a suitable amount of gas can be evaporated each time.

The power source 3 outputs, for example, a pulse-like high frequency voltage. It is desirous that the rising time/ falling time of this pulse is 10 $\mu$s or less, the electric field intensity between the electrodes 31, 32 is 10 to 1000 kV/cm, and the frequency is 0.5 kHz or more. The form of the voltage may be a sine-form instead of the pulse-form. As mentioned in the schematic construction, the peak-to-peak voltage $V_{pp}$ is determined in the range of several kV to several-tens kV. Here, it is established, for example, as $V_{pp}$ = 14 [kV].

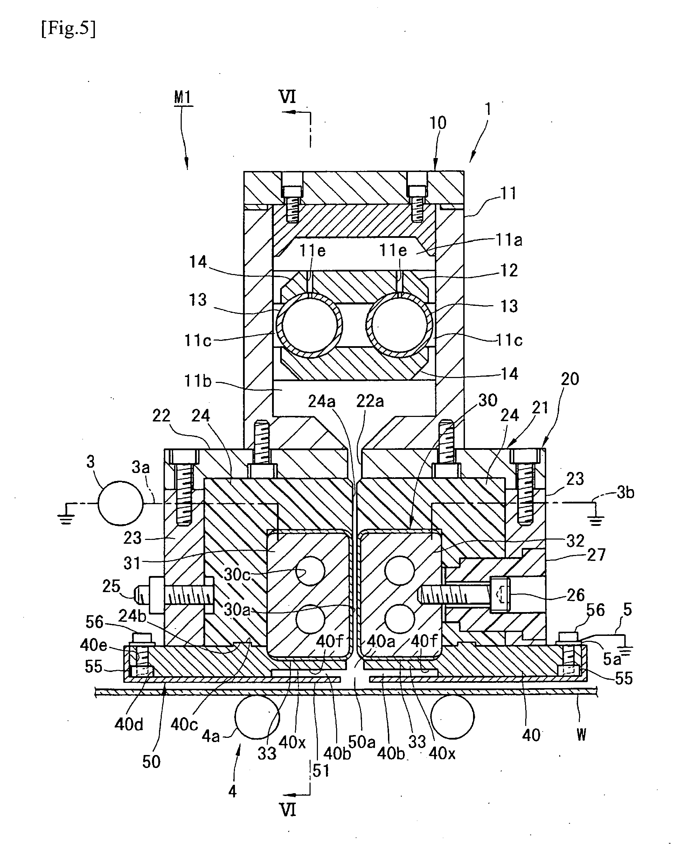

As shown in FIG. 5, the feed mechanism 4 includes a plurality of rollers 4a which are horizontally arranged side by side. A plate-like workpiece W having a large area is loaded on those rollers and fed leftward and rightward. A gas plasmatized by the nozzle head 1 is sprayed onto this workpiece W and a plasma surface processing such as, for example, cleaning is carried out. It is, of course, accepted that the workpiece W is fixed and the nozzle head 1 is movable.

The plasma nozzle head 1 of the plasma processing apparatus M1 will be described in detail.

The nozzle head 1 comprises an upper gas rectifier 10 and a lower discharge processor 20. The nozzle head 1 is extended in the back and forth direction orthogonal to the paper sheet surface of FIG. 5.

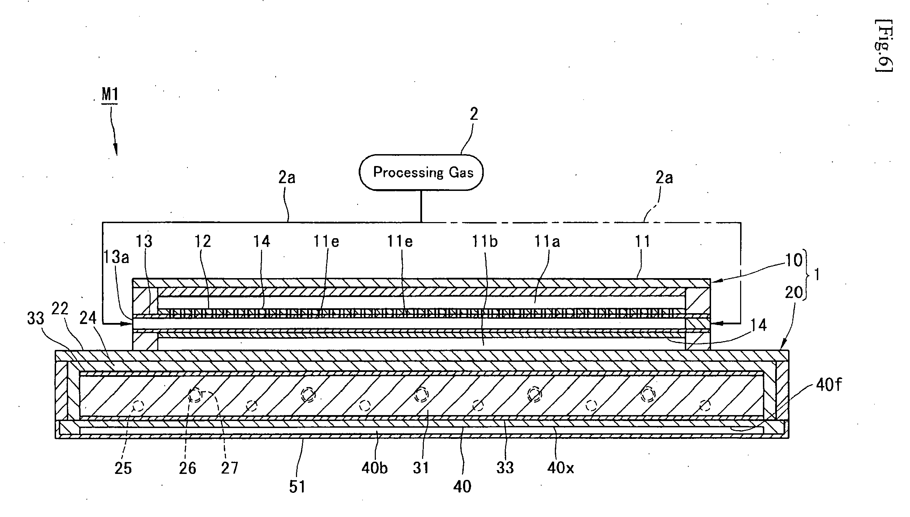

The gas rectifier 10 includes a container-like main body 11 which is elongated in the back and forth direction. A pipe unit 12 is received in this main body 11. The pipe unit 12 includes a pair of left and right pipes 13, 13 and a pair of upper and lower pipe holders 14, 14 for sandwichingly holding those pipes 13, 13. The pipe unit 12 is extended in the same direction as the main body 11. The interior of the main body 11 is divided into two upper and lower chambers 11a, 11b by the pipe unit 12. As shown in FIGS. 4 and 6, an inlet port 13a of the pipe 13 (one of the pipes 13, 13) is disposed at one end part in the longitudinal direction of the gas rectifier 10 and an inlet port 13a of the other pipe 13 is disposed at the other end part. End parts on the reverse side of the end parts on the ports 13a, 13a side of the respective pipes 13, 13 are choked with plugs, respectively.

The gas supply tube 2a extending from the processing gas source 2 is branched into two. Those two branch tubes are connected to a front end part of the pipe 13 and a rear end part of the other pipe 13, respectively. The processing gas fed from the processing gas source 2 is introduced into the two pipes 13, 13 via the tube 2a and flowed in the mutually reverse directions within the pipes 13, 13. A hole 11e is formed in the upper part of each pipe 13 and the upper pipe holder 14 in such a manner as to extend in the back and forth longitudinal direction. A plurality of holes 11e may be arranged at short intervals in the back and forth direction in a spotting state and they may be extending in the back and forth direction in a slit-like state. The processing gas in the pipes 13, 13 are leaked into the upper chamber 11a through this hole 11e. Thereafter, the processing gas is flowed into the lower chamber 11b through slit-like gaps 11c on the two sides of the pipe unit 12. Owing to this arrangement, the processing gas can be made uniform in the longitudinal direction.

The discharge processor 20 of the plasma nozzle head 1 will now be described.

As shown in FIGS. 5 and 6, the discharge processor 20 includes an electrode structure 30 composed of a pair of left and right electrodes 31, 32, and a holder 21 for holding this electrode structure 30.

Each electrode 31, 32 is composed of a conductive material such as, for example, stainless steel and formed in a square configuration in section. Each electrode 31, 32 is linearly extended in the back and forth direction orthogonal to the paper sheet surface of FIG. 5. The corners of each electrode 31, 32 are rounded in order to prevent an arc discharge from occurring. A plasma generating space 30a is formed between the electrodes 31, 32 and extended in the back and forth direction in a slit-like state. The thickness (distance between the electrodes 31, 32) of the plasma generating space 30a is, for example, 2 mm. A solid dielectric 33 composed of alumina having, for example, a relative dielectric constant $\varepsilon_A$ = 7.5 is deposited, in the form of a thin film, on the opposing surfaces and upper and lower surfaces of each electrode 30 by thermal spraying after those surfaces are subjected to sand blast processing. The thickness $t_A$ of the solid dielectric 33 is, for example, $t_A$ = 1 mm.

In FIG. 5, reference numeral 3a denotes a feeder wire leading from the power source 3 to the voltage applying electrode 31, and reference numeral 3b denotes an earthing wire leading from the grounding electrode 32. Reference numeral 30c denotes a refrigerant path for adjusting the electrode temperature (not shown in FIG. 6).

The holder 21 for the electrodes 30, 30 comprises an upper plate 22, a pair of left and right side plates 23, a pair of left and right angle members (angle holders) 24, and a lower part 50 (not shown in FIG. 4). Each angle member 24 is composed of an insulating resin and formed in an inverted L-shape in section. The angle member 24 is extended in the back and forth direction orthogonal to the paper sheet surface of FIG. 5. The angle member 24 is abutted with the upper surface and the rear surface of each electrode 30. A gap 24a is formed between the upper parts of the two angle members 24, 24. The gap 24a is connected to the upstream of the plasma generating space 30a between the electrodes 31, 32.

An upper plate 22 made of a rigid steel material is put on the upper surfaces of the two angle members 24, 24. A slit 22a extending in the back and forth direction is formed in the laterally central part of the upper plate 22. The slit 22a is connected to the downstream of the lower chamber 11b of the gas rectifier 10 and also connected to the upstream of the gap 24a. Owing to this arrangement, the processing gas fed from the gas rectifier 10 is introduced into the interelectrode space 30a via the slit 22a and the gap 24a.

A side plate 23 made of a rigid steel material is abutted with a rear surface (outer surface) of each angle member 24. The upper end part of each side plate 23 is rigidly bolted to the upper plate 22. An inverted U-shaped frame is formed by the upper plate 22 and the left and right side plates 23.

A plurality of push bolts 25 (electrode approaching means) and a plurality of pull bolts 26 (electrode departing means) are spacedly arranged on each side plate 23 in the longitudinal direction. The push bolts 25 are screwed into the side plate 23 and the tips of the push bolts 25 are abutted with the rear surface of the angle member 24. Thus, the push bolts 25 push the electrode 30 toward the other electrode through the angle member 24. The pull bolts 26 received in a bolt collar (bolt holder) 27 made of resin are screwed into the electrode 30 and pull the electrode 30 in the direction away from the other electrode. By adjusting the screwing amounts of those bolts 25, 26, distortion of the elongate electrodes 30, 30 can be corrected and the thickness of the interelectrode space 30a can be made constant over the entire length of the electrodes 30, 30. Moreover, the electrodes 31, 32 can be prevented from being distorted caused by the Coulomb force or by thermal stress, etc. generated by difference in thermal expansion between the metal main body and the dielectric layer 33 formed on the outer surface of the electrodes 31, 32 and difference in temperature within the electrodes 31, 32. As a result, the processing gas can reliably and uniformly be jetted downward (i.e., along the jetting axis orthogonal to the opposing direction of the electrodes 31, 32 and thus, the workpiece W can reliably and evenly be plasma processed.

The lower part 50 forming the bottom part of the holder 21 will now be described. The lower part 50 comprises a plate-like insulating member 40 and a conductive member 51 composed of a metal plate. The lower plate 50 is horizontally extended in the back and forth direction orthogonal to the paper sheet surface of FIG. 5. The lower part 50 is astride the left and right side plates 23, 23, the angle members 24, 24 and the lower surface of the electrode structure 30 and supports the component elements of the nozzle head 1 which are all located above the lower part 50 itself. Therefore, the lower part 50 covers the under surface to be directed to the workpiece W of the electrode structure 30 and shields the electrode structure 30 so that the electrode structure 30 is not directly faced with the workpiece W. In other words, the under surface to be directed to the workpiece W of the electrode structure 30 is covered with the conductive member 51 of the lower part 50 and an insulator 45 for insulating the electrode structure 30 from the conductive member 51 is interposed/loaded between the electrode structure 30 and the conductive member 51. The left and right end parts of the lower part 50 are protruded from the side plates 23, 23. Those left and right protruded parts are supported by support means not shown. The lower part 50 and the side plate 23 may be connected by bolting or the like.

As a material of the insulating member 40, glass having a relative dielectric constant of, for example, $\varepsilon_B = 44$ is used. A ridge 40c is formed on the upper surface of the insulating member 40 in such a manner as to extend in the back and forth longitudinal direction orthogonal to the paper sheet surface of FIG. 5. This ridge 40c is fitted into a concave groove 24b formed in the lower end surface of the angle hole 24.

A lead-out path 40a (jet path) is formed at the central part in the left and right width direction of the insulating member 40. The lead-out path 40a is in the form of a slit, extended long in the back and forth direction orthogonal to the paper sheet surface of FIG. 3 and connected to the downstream of the plasmatizing space 30a. The inner end surfaces, i.e., lead-out path forming surface, on the left and right sides of the lead-out path 40a in the insulating member 40 are slightly withdrawn laterally outward from the opposing surfaces of the electrodes 31, 32, i.e., plasmatizing space forming surface. Owing to this arrangement, the lead-out path 40a is larger in a flow path section area than the plasmatizing space 30a.

The both left and right end parts of the insulating member 40 are protruded from the side plates 23, 23.

The conductive member 51 entirely covers the under surface of the insulating member 40. The conductive member 51 is composed of, for example, a stainless steel plate. A jet port 50a is formed in the central part in the laterally central part of the conductive member 51. The jet port 50a is in the form of a slit, extended long in the back and forth longitudinal direction orthogonal to the paper sheet surface of FIG. 5 and connected to the downstream of the lead-out path 40a. Thus, the jet port 50a is connected to the plasmatizing space 30a of the electrode structure 30 through the lead-out path 40a. (Owing to this arrangement, the lower part 50 allows the processing gas to be jetted out) The edge surface of the jet port 50a is slightly withdrawn outwardly from the forming surface of the lead-out path 40a of the insulating member 40. Owing to this arrangement, the jet port 50a is larger in width, i.e., larger in flow path section area than the lead-out path 40a.

Instead of the integral unity, it is also accepted that the insulating member 40 is composed of a pair of left and right plate members and the lead-out path 40a is formed between those left and right plate members. Likewise, instead of the integral unity, it is also accepted that the conductive member 51 is composed of a pair of left and right plate members and the jet port 50a is formed between those left and right plate members.

The workpiece W is arranged under the conductive member 51. Owing to this arrangement, the nozzle head 10 can be brought closer to the workpiece W while preventing an arc discharge from occurring to the workpiece W, and plasma can reliably be applied to the workpiece W even under normal pressure.

Nuts 55 are fixed, by welding, to the upper surfaces of the both left and right side parts of the conductive member 51. On the other hand, recesses 40d for allowing the nuts 55 to insert therein are formed in the under surface of the insulating member 40. A bolt insertion holes 40e are formed in the insulating member 40 in such a manner as to extend to there recesses 40d from the upper surfaces. The metal-made bolts 56 are threadingly engaged with the corresponding nuts 55 through the insertion holes 40c, respectively. Owing to this arrangement, the conductive member 51 is fixed to the insulating member 40. A terminal 5a of the earthing lead wire 5 is engaged with the head part of the bolt 56. This lead wire 5 is grounded. Owing to this arrangement, the conductive member 51 is electrically grounded through the bolts 56 and the nuts 55.

Recesses 40f are formed in the under surfaces of the lower parts 40x of the electrodes 32, 32 in the insulating member 40. Owing to this arrangement, the gap 40b is positively formed between the insulating member 40 and the conductive member 51. The recess 40f and thus, the gap 40b is connected to the lead-out path 40a and the jet port 50a. The thickness d of the gap 40b is, for example, d = 1 mm.

In the normal pressure plasma processing apparatus M1, the thickness $t_B$ of the electrode underside part 40x (excluding the gap 40b) of the insulating member 40 ($\varepsilon_B = 4.4$) is established in such a manner as to satisfy the expression (2). For example, $t_B = 5$ mm. Owing to this arrangement, an arc discharge can be prevented from occurring to the gap 40b and the processing quality can be obtained.

One modified embodiment of the first embodiment will be described next.

As shown in FIG. 7, there is no need of a provision of the insulating member 40 between the electrodes 31, 32 and the conductive member 51. That is, the electrodes 31, 32 are located away from the conductive member 51 by a predetermined distance d, and the gap 40b is formed therebetween. Specifically, a solid dielectric 33 having a thickness $t_A$ and a relative dielectric constant $\varepsilon_B$ is deposited, in the form of a thin film, on the undersurface of the solid dielectric 33, and the gap 40b is defined by the undersurface of the solid dielectric 33 and the upper surface of the conductive member 51. The gap 40b is filled with air. Air serves as an insulator having a good dielectric strength. Owing to this arrangement, the gap, i.e., gas layer (air layer) 40b constitute the insulator for insulating the electrode 31 from the conductive member 51. In FIG. 7, the solid dielectric 33 is deposited on only the opposing surface and the undersurface of the electric field applying electrode 31 and not on the grounding electrode 32. However, the solid dielectric 33 may be deposited on both the electrodes 31, 32 as in FIG. 1.

The thickness d of the gas layer 40b is established in such a manner as that no dielectric breakage occurs to the gas layer 40b. That is, the voltage Vx applied between the solid dielectric 33 and the conductive member 51 located on the lower side of the electrode 31 becomes smaller than the sparking voltage Vxo. Specifically, the voltage Vx is established in such a manner as to satisfy the following expression.

$$Vxo > Vx = \varepsilon_A \, V_{pp} \, d \, / \, 2(t_A + {}_A d) \qquad (6)$$

The above-mentioned expression (6) is obtained by replacing $\varepsilon_B = 1$ and $t_B = 0$ in the previously mentioned expression (2). The sparking voltage Vxo serving as a standard desirously uses the lowest level experiment value (indicated by the broken line of FIG. 3) of the expression (5) rather than the document value (indicated by the one-dot chain line of FIG. 3) in the expression (3). Owing to this arrangement, an arc discharge can be prevented from occurring to the gas layer 40b. Also, by making Vx lower than Vxo irrespective of the value of d in the same manner as indicated by the solid line of FIG. 3, the arc discharge can reliably be prevented from occurring even if the thickness d of the gas layer 40b is varied by some reason. It is good enough if Vxo > Vx is satisfied in a predetermined range in which d includes an original value.

As shown in FIG. 8, it is also accepted that there is no provision of the insulating member 40 between the electrodes 31, 32 and the conductive member 51 and in addition, there is no provision of the solid dielectric 33 on the electric field applying electrode 31. Owing to this arrangement, the gas layer 40b is defined by the metal main body of the electrode 31 and the conductive member 51. In that case, the grounding electrode 32 is required to be provided at least at the confronting surface with the other electrode 31 with the solid dielectric 33.

In the embodiment of FIG. 8, the thickness d of the gas layer 40b is established such that the voltage Vx (= Vpp) applied between the electrode 31 and the conductive member 51 becomes smaller than the sparking voltage Vxo. As the sparking voltage Vxo, the lowest level experiment value (indicated by the broken line of FIG. 3) is desirously used rather than the document value (indicated by the one-dot chain line) of the expression (3) as in the case with the above-mentioned embodiment(s).

That is, based on the expression (5) showing the lowest level experiment value, the thickness d of the gas layer 40b in accordance with the applied voltage Vpp is established in such a manner as to satisfy the following expression.

$$Vpp \leq 8.65d \, / \, (1.52d + 1) \qquad (7)$$

Owing to this arrangement, an arc discharge can be prevented from occurring to the gas layer 40b.

Regarding the apparatus in the embodiment of FIG. 8, the range capable of confirming at least a small amount of arc discharge was measured under the condition of the thickness d = 1 mm of the gas layer 40b and by increasing/decreasing the supply voltage Vpp. The result was Vpp ≥ 3kV. From this, it was thoroughly confirmed that the expression (7) is in a sufficiently safe region.

FIG. 9 shows a modified embodiment of the configuration of the lead-out path forming part of the insulating member 40. In this modified embodiment, the corner formed between the upper surface (surface directed to the electrode structure 30) and the lead-out path 40a forming surface of the insulating member 40 is round chamfered, thereby forming a first chamfered part 40r. Also, the corner formed between the lead-out path 40a forming surface and the undersurface (surface directed to the conductive member 30) of the insulating member 40 is round chamfered, thereby forming a second chamfered part 40s.

Owing to a provision of the first chamfered part 40r, the corner formed between the upper surface and the lead-out path forming surface of the insulating member 40 can be prevented from being broken by plasma and particles can be prevented from generating. Thus, the processing quality can be enhanced and the yield of production can be increased.

The first chamfered part 40r is larger than the second chamfered part 40s. That is, the radius of curvature R of the first chambered part 40r is larger than that of the second chamfered part 40s. Owing to this arrangement, breakage of the corner formed between the upper surface and the lead-out path forming surface of the insulating member 40, and thus, generation of particles can reliably be prevented.

Instead of the round chamfering, the first and second chamfered parts may be formed by square chamfering.

In the modified embodiment of FIG. 9, the edge surface of the jet port 50a of the conductive member 51 is rounded like a semi-circular shape toward the upper surface directed to the insulating member 40 and the undersurface to be directed to the workpiece W. In other words, the corner formed by the upper surface and the jet port 50a edge surface of the conductive member 51 is round chamfered and the corner formed between the jet port 50a edge surface and the undersurface are round chamfered. Owing to this arrangement, an arch discharge can more reliably be prevented from occurring between the insulating plate 41 and the conductive member 51. It is also accepted that only the corner formed between the upper surface and the jet port 50a edge surface of the conductive member 51 is chamfered and the corner formed between the jet port 50a edge surface and the undersurface are not chamfered. Instead of round chamfering, square chamfering may be employed.

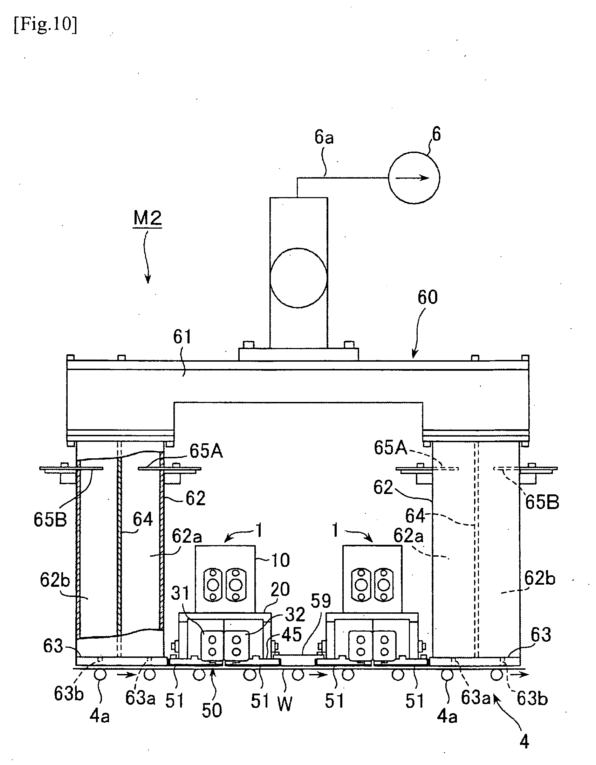

The second embodiment will be described with reference to FIGS. 10 through 12, next.
As shown in FIG. 10, a normal pressure plasma processing apparatus M2 according to the second embodiment comprises a processing gas source 2, a pulse source 3, a workpiece feed mechanism 4, a portal shaped frame 60 and a pair of left and right nozzle heads (processing head) 1. The processing gas source 2, the power source 3 and the feed mechanism 4 are same as in the apparatus M1 of FIGS. 4 through 6.

The portal shaped frame 60 includes left and right pedestrals 62, and is located above the feed mechanism 4. The portal shaped frame 60 has a hollow interior which constitutes an exhaust duct for the processed gas (including by-products generated by processing). That is, the interior of each pedestral 62 of the portal shaped frame 60 is partitioned into two inner and outer suction chambers 62a, 62b by a partition wall 64. Two inner and outer suction ports 63a, 63b, which are connected to the suction chambers 62a, 62b, respectively, are formed in the bottom plate 63 of the pedestral 62. The suction ports 63a, 63b are in the form of a slit extending in the back and forth direction orthogonal to the paper sheet surface of FIG. 10. However, those ports 63a, 63b may be a plurality of slit-like holes arranged in the direction orthogonal to the paper sheet surface.

The upper end parts of the inner and outer suction chambers 62a, 62b are connected to the hollow interior of an upper frame part 61 of the portal shaped frame 60. A suction tube 6a is extended from a central part of the upper frame part 61 and this suction tube 6a is connected to an exhaust pump 6. By actuating the exhaust pump 6, the processed gas in the nozzle head 1 is sucked into the inner suction chamber 62a from the inner suction port 63a. The processed gas left unsucked and atmospheric air are sucked into the outer suction chamber 62b from the outer suction port 63b. Owing to this arrangement, the processed gas can reliably be prevented from being unsucked. By preventing the atmospheric air from being sucked through the inner suction port 63a, only the processed gas can be sucked into the inner suction port 63a. The gas sucked into the respective chambers 62a, 62b is converged in the interior of the upper frame part 61 and then, exhausted by the exhaust pump 6 via the suction tube 6a.

Two inner and outer throttle plates 65A, 65B are advanceably/retractably provided to the upper part of each pedestral 62. The throttling amounts in the chambers 62a, 62b can be adjusted by the throttle plates 65A, 65B, respectively, and thus, the sucking amounts of gas through the suction ports 63a, 63b can also be adjusted, respectively.

The normal pressure processing apparatus M2 has a pair of left and right nozzle heads 1 which are located above the roller 4a, i.e., above the moving plane of the workpiece W and supported between the left and right pedestrals 62 of the portal shaped frame 60. The left and right nozzle heads 1 have the same construction.
As shown in FIG. 10, in the apparatus M2, one of the lower part 50 is connected to the other lower part 50 of the adjacent nozzle head 1 through a connection plate 59. The connection plate 59 and the lower part 50 are connected to each other by bolts 56.

As shown in FIG. 11, in the nozzle head 1 of the apparatus M2, the construction of the lower part 50 is partly different from that of the apparatus M1. Specifically, the lower part 50 of the apparatus M2 comprises an insulator 45 and a conductive member 51 and is horizontally extended in the back and forth direction orthogonal to the paper sheet surface of FIG. 11. The insulator 45 is composed of a first insulating plate 41 located on the inner side and a second insulating plate 42 located on the outer side. That is, the insulator 45 is constituted by a first insulating part 41 composed of a plate-like solid insulator and a second insulating part 42 composed of a plate-like solid insulator separately made from the first insulating part 41.

The first insulating plate 41 is small in width and extended forwardly and backwardly. The second insulating plate 42 is large in width and its left and right end parts are protruded from the side plate 23. A slit-like opening extending in the back and forth direction is formed in the laterally central part of the second insulating plate 42. The first insulating plate 41 is fitted to this slit-like opening. Steps are formed on the inner edge on the both left and right sides of the slit-like opening of the second insulating plate 42 and the outer edge on the both left and right sides of the first insulating plate 42. With those steps engaged with each other, the first and second insulating plates 41, 42 are jointed together in the manner of a half-lap joint.

A lead-out path 40a (jet path) is formed at the central part in the laterally widthwise direction of the first insulating plate 41. The lead-out path 40a is in the form of a slit and extended long in the back and forth direction orthogonal to the paper sheet surface of FIG. 11. The entire back and forth length of the lead-out path 40a is connected to the lower end part, i.e., downstream end, of the plasmatizing space 30a of the electrode structure 30. The lead-out path 40a forming surface of the first insulating plate 41 is slightly withdrawn laterally outwardly from the confronting surfaces, i.e., plasmatizing space 30a forming surface, of the electrodes 31, 32 as in the case with the insulating member 40 of the apparatus M1. Owing to this arrangement, the lead-out path 40a is larger in width, i.e., larger in flow path section area, than the plasmatizing space 30a.

The second insulating plate 42 is arranged on the reverse side of the lead-out path 40a of the first insulating plate 41. A ridge 40c is formed on the upper surface of the second insulating plate 42. This ridge 40c is fitted to the concave recess 24b of the angle member 24.

The first and second insulating plates 41, 42 are composed of mutually different solid insulating materials. The first insulating plate 41 is composed of a material having a plasma resistance property. More particularly, the first insulating plate 41 is composed of a material having a higher plasma resistance property than the second insulating plate 42. For example, the first insulating plate 41 is composed of quartz, while the second insulating plate 42 is composed of vinyl chloride. In general, the material having a high plasma resistance property like quartz is expensive when compared with vinyl chloride which does not have a high plasma resistance property.

The conductive member 51 is tightly attached to the undersurfaces of the first and second insulating plates 41, 42. No gap is formed between the conductive member 51 and the insulator 45. However, by presuming that a gap imaginarily having a thickness d is provided and by establishing the dielectric constant and the thickness of the insulator 45 ( particularly the first insulting plate 41) in such a manner as to satisfy the expression (2) irrespective of the size dimension of d, an arc discharge can be prevented from occurring between the conductive member 51 and the insulator 45. As in the case with the above-mentioned apparatus M1, the edge surface of the jet port 50a of the conductive member 51 is slightly withdrawn outwardly from the surface for forming the lead-out path 40a of the first insulating plate 41. Owing to this arrangement, the jet port 50a becomes larger in width, i.e., larger in flow path section area, than the lead-out path 40a.

Instead of the integral unity, the first and second insulating parts 41, 42 may be composed of the pair of left and right plate members and the lead-out path 40a may be formed between the pair of plate members of the first insulating part 41. Likewise, instead of the integral plate, the conductive member 51 may be composed of the pair of left and right plate members and the jet port 50a may be formed between those plate members.

As shown in FIG. 12, an insulating resin-made spacer 34 for maintaining the thickness of the plasmatizing space 30a is sandwiched between the both end parts in the longitudinal direction of the electrodes 31, 32. It is desirous that a rounded avoidance part 51a is formed on the both end parts in the longitudinal direction of the jet port forming end surface of the conductive member 51, so that the conductive member 51 is kept away from the boundary between the electrodes 31, 32 and the spacer 34.

According to the normal pressure plasma processing apparatus M2 thus constructed, even if an electric charge is accumulated on the insulating members 41, 42, the electric charge can be released to the earth through the conductive member 51 and an electric discharge from the insulating members 41, 42 to the workpiece W can be prevented from occurring.

The first insulating plate 41 forming the lead-out path 40a is composed of a quartz glass. By doing so, a plasma resistance property can be obtained. On the other hand, the second insulating plate 42, which is not exposed to plasma, is composed of an inexpensive vinyl chloride. By doing so, the material cost can be reduced when compared with a case wherein the entire insulator 45 is composed of quartz. Since the surface for forming the lead-out path 40a of the first insulating plate 41 is withdrawn from the surface for forming the plasmatizing space 30a of the electrode structure 30, the first insulating plate 41 can more reliably be prevented from being damaged by plasma.

The edge surface of the jet port 50a of the conductive member 51 is withdrawn from the surface for forming the plasmatizing space 30a of the electrode structure 30 and also withdrawn from the surface for forming the lead-out path 40a of the first insulating plate 41. Owing to this arrangement, an electric discharge can reliably be prevented from occurring between the electrode 31 and the jet port edge part of the conductive member 51.

The both end parts in the longitudinal direction of the elongate nozzle head 1 is such designed as to keep away from the boundary between the spacer 34 and the electrodes 31, 32. Owing to this arrangement, a surface discharge occurable at the boundary between the spacer 34 and the electrodes 31, 32 can be prevented from conducting to the conductive member 51.

A modified embodiment of the second embodiment will be described next.

As mentioned above, in the apparatus M2 of FIG. 11, the jet port edge surface of the conductive member 51 is withdrawn from the plasmatizing space forming surface of the electrode structure 30, thereby preventing an electric discharge from occurring to the conductive member 51 from the electrode 31. However, the positional relation of those surfaces may be reversed in accordance with necessity.

That is, as shown in FIG. 13, the edge surface of the jet port 50a of the conductive member 51 may be protruded from the surface for forming the lead-out path 40a of the insulating member 41 and also protruded from the surface for forming the plasmatizing space 30a of the electrodes 31, 32. Owing to this arrangement, the jet port 50b becomes smaller in width than the plasmatizing space 30a. This makes it possible to throttle the processing gas in the jet port 50a so that the gas can be applied to the workpiece W sharply and reliably. As a result, the processing efficiency can further be enhanced. Moreover, the processing gas heated in the plasmatizing space 30a can be sprayed onto the workpiece W in its temperature-increased state.

In the alternative, as shown in FIG. 14, the edge surface of the jet port 50a of the conductive member 51 may be protruded from the surface for forming the lead-out path 40a of the insulating member 41 and flush with the surface for forming the plasmatizing space 30a of the electrodes 31, 32. Owing to this arrangement, the jetting speed of the processing gas can be prevented from becoming slow and the processing efficiency can be enhanced.

In the apparatus M2 of FIG. 11, the outer end surface of the conductive member 51, i.e., the rear surface on the reverse side of the jet port 50a in the respective left and right parts with the jet port 50a of the conductive member 51 sandwiched therebetween is protruded outwardly from the outer surfaces of the electrodes 31, 32, i.e., the rear surface on the reverse side of the plasmatizing space 30a. As shown in FIGS. 13 and 14, however, those surfaces may be flush with each other.

Moreover, as shown in FIG. 15, the outer end surface of the conductive member 51 may be located inside the outer surfaces of the electrodes 31, 32 and near the jet port 50a.

The insulator 45 may include not only the first and second insulating plates 41, 42, i.e. solid insulating members but also air layers composed of air and the like, i.e., gas insulators. For example, as shown in FIG. 16, it is also accepted that the insulating plates 41, 42 and the conductive member 51 are separated from each other by a predetermined distance d and a gap 40b is formed therebetween. The gap 40b is filled with air. Air is an insulator having a good dielectric strength. The gap, i.e., gas layer (air layer) 40b constitutes the insulator 45 which co-acts with the solid insulating plates 41, 42 to insulate the electrode from the conductive member 51. The thickness of the gas layer 40b, i.e., distance d between the insulating plates 41, 42 and the conductive member 51 established such that the voltage applied to the gas layer 40b becomes smaller than the sparking voltage.

The second insulating part of the insulating means 45 may be composed of a gas layer instead of the insulating plate 42. Specifically, as shown in FIG. 17, a gap, i.e., a gas layer 42S (insulating air layer) is defined between the electrode structure 30 and the conductive member 51 and outside (on the reverse side of the lead-out path 40a) the first insulating plate 41. The second insulating part is composed of this gas layer 42S. According to this modified embodiment, since there is no need of a provision of the second insulating plate 42, the material cost can further be reduced.

In FIGS. 13 through 17, the solid dielectric layer 33 of the electrodes 31, 32 is not shown.

FIG. 18 is a view in which the same modification as in FIG. 9 is applied to the configuration of the lead-out path forming part of the first insulating plate 41. That is, the corner formed between the upper surface (surface directed to the electrode structure 30) of the first insulating plate 41 and the surface for forming the lead-out path 40a is square chamfered to provide a predetermined angle (for example, 45 degrees), thereby forming the first chamfered part 41a. Also, the corner formed between the surface for forming the lead-out path 40a and the undersurface (surface directed to the conductive member 30) of the first insulating plate 41 is square chamfered to provide a predetermined angle (for example, 45 degrees), thereby forming the second chamfered part 41b.

Owing to a provision of the first chamfered part 41a, the corner formed between the upper surface and the lead-out path forming surface of the first insulating plate 41 can be prevented from being broken by plasma and particles can be prevented from generating. Thus, the processing quality can be enhanced and the yield of production can be enhanced, too. The first chamfered part 41a is larger than the second chamfered part 41b. Owing to this arrangement, the corner formed between the upper surface and the lead-out path forming surface of the first insulating plate 41 can reliably be prevented from occurring and thus, particles can reliably be prevented from generating.

Moreover, in the modified embodiment of FIG.18, the edge surface of the jet port 50a of the conductive member 51 is located in the same position in the left and right direction with respect to the boundary between the second chamfered part 41v and the undersurface of the first insulating plate 41. Owing to this arrangement, an arc discharge can reliably be prevented from occurring between the electrode 51 and the conductive member 51. Moreover, since the jet port 50a becomes larger than the lead-out path 40a, the processing gas can smoothly be jetted out.

The edge surface of the jet port 50a of the conductive member 51 may be withdrawn laterally outwardly from the boundary between the second chamfered part 41b and the undersurface of the first insulating part.

FIG. 19 shows another modified embodiment of the chamfering. In this modified embodiment, the chamfering of the first insulating plate 41 is round chamfering instead of square chambering. Specifically, the corner formed between the upper surface and the surface for forming the lead-out path 40a of the first insulating plate 41 is round chamfered, thereby forming the first chamfered part 41 c, while the corner formed between the surface for forming the lead-out path 40a and the undersurface is round chamfered, thereby forming the second chamfered part 41d. The radius of curvature of the first chamfered part 41c is larger than that of the second chamfered part 41 d.

FIG. 20 is a view in which the same modification as in FIG. 9 is applied to the configuration of the jet port forming part of the conductive member 51. That is, the edge surface of the jet port 50a of the conductive member 51 is semicircularly rounded toward the upper surface directed to the first insulating plate 41 and toward the undersurface to be directed to the workpiece W, respectively. In other words, the corner formed between the upper surface and the edge surface of the jet port 50a of the conductive member 51 is round chambered, while the corner formed between the edge surface of the jet port 50a and the undersurface is round chamfered. Owing to this arrangement, an arc discharge can more reliably be prevented from occurring between the electrode 31 and the conductive member 51 or between the insulating plate 41 and the conductive member 51. It is also accepted that only the corner formed between the upper surface and the edge surface of the jet port 50a of the conductive member 51 is chamfered and the corner formed between the edge surface of the jet port 50a and the undersurface is not chamfered. Instead of the round chamfering, a square chamfering may be employed.

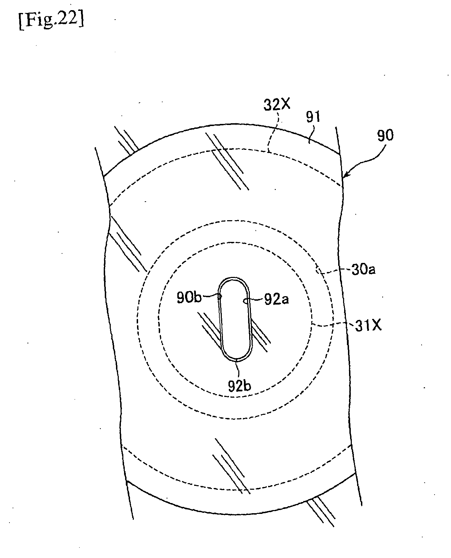

A normal pressure plasma processing apparatus M3 according to the third embodiment will be described next, with reference to FIGS. 21 and 22.

As shown in FIG. 21, the normal pressure plasma processing apparatus M3 is an apparatus for performing, for example, a plasma etching as a plasma surface processing. A processing gas source 2X of the apparatus M3 reserves, for example, $CF_4$ or the like as a processing gas for plasma etching.

The apparatus M3 comprises a cylindrical nozzle head 70 instead of the elongate nozzle head 1. This cylindrical nozzle head 70 is supported on a mount table (not shown) with its axis directed upward and downward. A workpiece W' to be etched is arranged under this nozzle head 70.

The cylindrical nozzle head 70 will be described in detail.

The cylindrical nozzle head 70 comprises a body with its axis directed upward and downward, an insulating holder 80 loaded within this body 71, and an electrode structure 30X. The body 71 has a three-stage cylindrical configuration formed by vertically connecting three body component members 72, 73, 74 which are made of conductive metal. The insulating holder 80 has a cylindrical configuration formed by vertically connecting three holder component members 81, 82, 83 which are made of insulating resin.

An electrode structure 30X of the apparatus M3 has a coaxial double annular configuration. That is, an electric field applying electrode 31X is mounted on the holder component member 83 on the lower stage. The electric field applying electrode 31X has a bottomed cylindrical configuration coaxial with the body. A solid dielectric layer 33 is deposited on the outer surface of the electric field applying electrode 31X. A lower end part of a conductive metal-made pipe 35, which is coaxial with the body, is inserted in the electric field applying electrode 31X. The conductive pipe 35 is conducted at its intermediate part with the electrode 31X through a conductive ring 36. An upper end part of the conductive pipe 35 is projected upward of the holder 81 and connected to a pulse source 3 (electric field applying means).

A grounding electrode 32X is mounted on the inner periphery of the body component member 74 on the lower stage. The grounding electrode 32X is grounded through the conductive body 71 and an earthing lead wire 5 extending from the body 71. The grounding electrode 32X has a cylindrical configuration which is coaxial with the body 71 and which is larger in diameter and smaller in length than the electric field applying electrode 31X. The electric field applying electrode 31X is inserted and arranged in this grounding electrode 32X. That is, the grounding electrode 32X surrounds the electric field applying electrode 31X. Owing to this arrangement, an annular plasmatizing space 30b is formed between those electrodes 31X, 32X. The solid dielectric layer 33 is deposited on the inner peripheral surface of the grounding electrode 32X.

A refrigerant for temperature adjustment is sent into the open upper end of the pipe 35. After passing through the pipe 35, this refrigerant passes between the inner periphery of the electric field applying electrode 31X and the outer periphery of the pipe 35 and adjusts the temperature of the electrode 31X. Then, via a communication water path (not shown) formed in the holder component member 83 and the body component member 74, the refrigerant passes through an annular space 70d formed between the outer periphery of the grounding electrode 32X and the body component member 74 and adjusts the temperature of the electrode 32X. Thereafter, the refrigerant is discharged through a discharge path (not shown) extending through the body component member 74, the holder component members 83, 82, and the body component member 72 in sequence.

The processing gas fed from the processing gas source 2X is introduced into the annular plasmatized space 30b via a processing gas supply path 70b formed in the body component member 72, the holder component members 82, 83, etc. of the nozzle head 71 and then, via a swirl forming path 84a of a ring (swirl forming member) 84. On the other hand, the pulse voltage fed from the pulse source 3 is applied to the electrode 31X via the conductive pipe 35 and the conductive ring 36. Owing to this arrangement, an electric field is formed in the plasmatizing space 30b and the processing gas is plasmatized.

The swirl forming ring 84 is mounted on the holder component member 83 in such a manner as to surround the electric field applying electrode 31X on the upper side of the grounding electrode 32X. The swirl forming path 84a includes an annular path 84b extending along the outer periphery of the ring 84 and a plurality of swirl guide holes 84c penetrating through the inner peripheral surface of the ring 84 from a plurality of positions in the peripheral direction of the annular path 84b. The annular path 84b delivers the processing gas over the entire periphery in the peripheral direction from the processing gas supply path 70b. The swirl guide holes 84c are fine paths extending generally along the tangential direction of the inner periphery of the ring 84 and inclined downward toward the inner peripheral surface. The processing gas coming from the annular path 84b is passed through the swirl guide holes 84c and turned out to be a high-speed swirl flow along the peripheral direction of the annular plasmatizing space 30b. Owing to this arrangement, the flow distance in the plasmatizing space 30b of the processing gas can be elongated, the plasma density can be increased and the processing gas can be vigorously jetted out and reliably applied to the workpiece W'. Thus, the etching rate can be enhanced.

A lower part 90 (nozzle component part) is arranged under the body component member 74 on the lower stage of the cylindrical nozzle head 70. The lower part 90 includes an outer nozzle piece 91 and an inner nozzle piece 92.

The inner nozzle piece 92 is composed of an insulating resin such as, for example, polytetrafuluoroethylene and constitutes the "first insulating part". The inner nozzle piece 92 has a disc-like configuration smaller in diameter than the outer nozzle piece 91 but slightly more enlarged in diameter than the grounded electrode 32X. A lead-out path 92a is formed at the central part of the inner nozzle piece 92. The lead-out path 92a has a funnel-shaped configuration coaxial with the electrode 31X and its upper tapered part is connected to the plasmatizing space 30b. A lower end part of the electrode 31X is faced with the upper tapered part of the lead-out path 92a. As shown in Fig. 13, a lower straight part of the funnel-shaped lead-out path 92a has an elliptical configuration in a bottom view. A lower end part of the lead-out path 92a is opened downward and constitutes a jet port.

As shown in FIG. 21, an inverted projection 92b for forming the lower straight part of the lead-in path 92a is provided to the center of the undersurface of the inner nozzle piece 92. The outer peripheral surface of the inverted projection 92b is progressively reduced in diameter downwardly. This outer peripheral surface is intersected with the inner peripheral surface of the lower straight part of the lead-in path 92a, thereby forming the lower end (tip end) of the inverted projection 92b into a knife edge configuration.

The outer nozzle piece 91 is composed of a conductive metal such as, for example, stainless steel and constitutes a "conductive member". The outer nozzle piece 91 has a disc-like configuration having the same diameter as the body component member 74. The outer nozzle piece 91 is fixed to the lower end surface of the body component member 74 by bolts (not shown). The outer nozzle piece 91 is electrically grounded through the body 71 and the earthing lead wire 5.

A recess 91a is formed in the upper surface of the outer nozzle piece 91. The inner nozzle piece 92 is received in this recess 91a. A spacer (not shown) for raising the inner nozzle piece 92 is integrally provided to the inner bottom of the recess 91a of the outer nozzle piece 91 or the undersurface of the inner nozzle piece 92. Owing to this arrangement, a gap 90s is formed between the outer nozzle piece 91 and the inner nozzle piece 92. The gap 90s constitutes a "second insulating part composed of a gas layer". The gap 90s serving as the second insulating part and the inner nozzle piece 92 serving as the first insulating part constitute an insulator for insulating the electrode structure 30X from the outer nozzle piece 91, i.e., the conductive member.

The upper end part of the gap 90s is in communication with a suction path 70c. The suction path 70c is formed in the body component member 74, the holder component members 83, 82 and the body component member 72 in sequence. The upper end part of the suction path 70c is connected to the exhaust pump 6 through the suction tube 6a.

A hole part 91b, which is open to the under surface of the outer nozzle piece 91, is formed in the central part of the recess 91a of the outer nozzle piece 91. As shown in FIG. 22, the opening to the undersurface of the piece 91 of the hole part 91b has an elliptical configuration slightly larger than the lower end edge of the inverted projection 92b. As shown in FIG. 21, the inverted projection 92b of the inner nozzle piece 92 is inserted in and arranged at the hole part 91b. (That is, the hole part 91b having the jet path 92a of the inner nozzle piece 92 at its inner side is formed in the outer nozzle piece 91.) The gap 90s is open to the undersurface of the outer nozzle piece 91 through a space formed between the inner peripheral surface of the hole part 91b and the outer peripheral surface of the inverted projection 92b. Owing to this arrangement, the gap 90s serving as the second insulating part constitutes a "suction path" having the hole part 91b serving as its suction port. As mentioned above, the tip of the inverted projection 92b is sharpened like a knife edge, thereby the inner peripheral edge of the opening of the gap 90s and the outer peripheral edge of the opening of the lead-in path 92a are contacted with each other.

In the apparatus M3, since the conductive metal-made outer nozzle piece 91 is arranged, in its electrically grounded state, between the electrode structure 30X and the workpiece W, the nozzle head 70 can be brought closer to the workpiece W' without inferior processing and damage of the workpiece W' which would otherwise be caused by the arc discharge. Thus, the plasma processing efficiency can reliably be enhanced. The electrode structure 30X and the outer nozzle piece 91 can reliably be insulated one from the other by an insulating means composed of the inner nozzle piece 92 and the gap 90s.

The gap 90s formed between the outer nozzle piece 91 and the inner nozzle piece 92 is provided as a second insulating part capable of insulating the electrode 31X from the outer nozzle piece 91. In addition, the gap 90s is also provided as a suction part which is caused to suck the processed gas (including by-products generated by etching) upon actuation of the exhaust pump 6. The processed gas can be discharged through the exhaust pump 6 from the gap 90s serving as the suction path via the suction path 70c and suction tube 6a in sequence. A flow rate control valve 6b (suction flow rate adjusting means) is inserted in the suction tube 6a so that the sucking flow rate can be adjusted.

The present invention is not limited to the above embodiments but other various embodiments can be employed without departing from the spirit of the invention.

For example, the conductive member may be provided to at least the voltage applying electrode and it is not required to be provided to the grounding electrode.

The insulator may be provided at least between the voltage applying electrode and the conductive member and it is not required to be provided between the grounding electrode and the conductive member.

The solid dielectric 33 provided to the confronting surfaces and the undersurfaces of the electrodes 31, 32 may be composed of a dielectric thin plate separated made from the metal main body of the electrodes 31, 32 instead of the thermally sprayed film.

The present invention can be applied to plasma processing not only under normal pressure but also under reduced-pressure. The present invention can be applied not only to plasma processing utilizing a glow discharge but also to plasma processing utilizing other electric discharges such as a corona discharge. Moreover, it can be universally applied to various plasma processing such as cleaning, etching, film depositing, surface modification, ashing and the like.

[INDUSTRIAL APPLICABILITY]

The present invention can be utilized to surface processing such as cleaning, etching, film depositing and the like with respect to a substrate, for example, in the semiconductor manufacturing process.

[BRIEF DESCRIPTION OF DRAWINGS]

FIG. 1 is a front sectional view showing a schematic construction of a plasma processing apparatus according to the first embodiment of the present invention.

FIG. 2 is a schematic view of an experiment equipment for obtaining a sparking voltage expression at the lowest level.

FIG. 3 is a graph showing the voltage with respect to the thickness of a gap formed between an insulating member and a metal plate (conductive member).

FIG. 4 is a perspective view of a nozzle head of a normal pressure plasma processing apparatus according to one specific mode of the first embodiment.

FIG. 5 is a front sectional view of the apparatus according to the above-mentioned specific mode.

FIG. 6 is a side sectional view of the apparatus, taken on line VI-VI of FIG. 5.

FIG. 7 is a sectional view showing a modified embodiment of the first embodiment.

FIG. 8 is a sectional view showing another modified embodiment of the first embodiment.

FIG. 9 is a sectional view showing a further modified embodiment of the first embodiment.

FIG. 10 is a front view of a normal pressure plasma processing apparatus according to the second embodiment of the present invention.

FIG. 11 is a sectional view of a nozzle head of the second embodiment.

FIG. 12 is an enlarged bottom view of an end part in the longitudinal direction of the nozzle head of the second embodiment.

FIG. 13 is a sectional view showing a modified embodiment of the second embodiment.

FIG. 14 is a sectional view showing another modified embodiment of the second embodiment.

FIG. 15 is a sectional view showing a further modified embodiment of the second embodiment.

FIG. 16 is a sectional view showing a still further modified embodiment of the second embodiment.

FIG. 17 is a sectional view showing a yet further modified embodiment of the second embodiment.

FIG. 18 is a sectional view showing an additional modified embodiment of the second embodiment.

FIG. 19 is a sectional view showing another additional modified embodiment of the second embodiment.

FIG. 20 is a sectional view showing a further additional modified embodiment of the second embodiment.

FIG. 21 is a vertical sectional view of a cylindrical nozzle head of a normal pressure plasma processing apparatus according to the third embodiment of the present invention.

FIG. 22 is an enlarged bottom view of the cylindrical nozzle head.

[DESCRIPTION OF THE REFERENCE NUMERALS]

| M, M1, M2, M3 | normal pressure plasma processing apparatus |
|---|---|
| W, W' | workpiece (object to be processed) |
| 1 | elongate nozzle head |
| 5 | earthing lead wire |
| 3 | pulse source (electric field applying means) |
| 30, 30X | electrode structure |
| 30a, 30b | plasmatizing space |
| 31, 31X | voltage applying electrode |
| 32, 32X | grounding electrode |

| 33 | solid dielectric |
| --- | --- |
| 34 | spacer |
| 40a | lead-out path |
| 40b | gap, gas layer |
| 40 | insulating member |
| 40r, 40s | chamfered part |
| 41 | first insulating plate (first insulating part) |
| 42 | second insulating plate (second insulating part) |
| 42S | gap (second insulating part) |
| 45 | insulator |
| 51 | conductive member |
| 51a | avoidance part |
| 50a | jet port |
| 70 | cylindrical nozzle head |
| 90s | gap (second insulating part and suction path) |
| 91 | outer nozzle piece (conductive member) |
| 91b | hole part |
| 92 | inner nozzle piece (first insulating part) |
| 92a | lead-out path |

**Claims**

1. An apparatus for processing the surface of a workpiece, by jetting a plasmatized gas passed through a plasmatizing space onto a workpiece arranged outside the plasmatizing space, comprising:

   an electrode for forming said plasmatizing space;
   a conductive member arranged in such a manner as to shield the side of said electrode which is to be directed to said workpiece in a state that said conductive member is electrically gounded; and
   an insulating member composed of an insulator interposed between said electrode and said conductive member, said insulating member having such a dielectric constant and a thickness that the voltage between said insulating member and said conductive member does not reach the sparking voltage level.

2. A plasma processing apparatus according to claim 1, wherein a solid dielectric is disposed at a plasmatizing space forming surface and said surface to be directed to said workpiece of said electrode, and said insulating member is laid on the side of said workpiece of said solid dielectric.

3. A plasma processing apparatus according to claim 1, wherein said conductive member includes a surface directed to said insulating member, an edge surface for forming a jet port connected to said plasmatizing space and a surface to be directed to said workpiece, a corner is formed between said surface directed to said insulating member and an edge surface of said jet port and a corner is formed between said edge surface of said jet port and said surface to be directed to said workpiece, and at least the former corner is chamfered.

4. A plasma processing apparatus according to claim 1, wherein said conductive member includes a surface directed to said insulating member, an edge surface for forming a jet port connected to said plasmatizing space and a surface to be directed to said workpiece, and said jet port edge surface is rounded toward said surface directed to said insulator and said surface to be directed to said workpiece, respectively.

5. A method for manufacturing the plasma processing apparatus according to claim 1, wherein the dielectric constant and the thickness of said insulating member are established such that the voltage applied between said insulating member and said conductive member becomes smaller than the sparking voltage irrespective of the separation distance, i.e., the thickness of a gap formed between said insulating member and said conductive member.

6. A method for manufacturing the plasma processing apparatus according to claim 1, wherein an experiment for measuring said sparking voltage is carried out and a relation of said sparking voltage with respect to the separation distance, i.e., the thickness of a gap formed between said insulating member and said conductive member is obtained based on the measured data in which a spark occurs at a lower level than the average.

7. An apparatus for processing the surface of a workpiece by jetting a processing gas passed through a plasmatizing space onto a workpiece which is arranged outside said plasmatizing space, said plasma processing apparatus comprising:

   an electrode for forming said plasmatizing space;
   a conductive member provided in such a manner as to shield the side to be directed to said workpiece of said electrode in a state that said conductive member is electrically grounded; and
   an insulating member composed of an insulator and interposed between said electrode and said conductive member,
   a gap being formed between said insulating member and said conductive member, the dielectric constant and the thickness of said insulating member being established such that a voltage applied to said gap becomes smaller than the sparking voltage.

8. An apparatus for processing the surface of a workpiece by jetting a processing gas passed through a plasmatizing space onto a workpiece which is arranged outside said plasmatizing space, said plasma processing apparatus comprising:

   an electrode for forming said plasmatizing space; and
   a conductive member provided in such a manner as to shield the side to be directed to said workpiece of said electrode in a state that said conductive member is electrically grounded,
   a gas layer as an insulator being formed between said electrode and said conductive member, and the thickness of said gas layer being established such that a voltage applied between said electrode and said conductive member becomes smaller than the sparking voltage.

9. A plasma processing apparatus according to claim 8, wherein a solid dielectric is provided to a plasmatizing space forming surface and a surface on the side to be directed to said workpiece of said electrode, said gas layer is defined by said solid dielectric on the side of said workpiece and said conductive member, and the thickness of said gas layer is established such that a voltage between said solid dielectric on the side of said work piece and said conductive member becomes smaller than the sparking voltage.

10. A plasma processing apparatus according to claim 8, wherein said conductive member includes a surface directed to said electrode, an edge surface for forming a jet port connected to said plasmatizing space, and a surface to be directed to said workpiece, a corner is formed between said surface directed to said electrode and said jet port edge surface and a corner is formed between said jet port edge surface and said surface to be directed to said workpiece, and at least the former corner is chamfered.

11. A method for manufacturing the plasma processing apparatus according to claim 8, wherein an experiment for measuring said sparking voltage is carried out and a relation of said sparking voltage with respect to the thickness of said gas layer is obtained based on the measured data in which a spark occurs at a lower level than the average.

12. A method for manufacturing the plasma processing apparatus according to claim 9, wherein the thickness of said gas layer is established such that the voltage between said solid dielectric on the side of said workpiece and said conductive member becomes smaller than the sparking voltage irrespective of the separation distance between said electrode and said conductive member.

13. An apparatus for carrying out plasma processing by plasmatizing a processing gas and jetting the plasmatized gas onto a workpiece, said plasma processing apparatus comprising:

   an electrode structure composed of a pair of electrodes for forming a plasmatizing space;
   a conductive member arranged in such a manner as to shield the side to be directed to said workpiece of said electrode structure in a state that said conductive member is electrically grounded; and
   an insulator interposed between said electrode structure and said conductive member,
   said insulator being divided into a first insulating part for forming a processing gas lead-out path connected to the downstream of said plasmatizing space and a second insulating part separately arranged on the reverse side of said first insulating part lead-out path side.

14. A plasma processing apparatus according to claim 13, wherein said first insulating part is composed of an insulating material having a higher plasma resistance property than said second insulating part.

**15.** A plasma processing apparatus according to claim 13, wherein said first insulating part is composed of an insulating material having a plasma resistance property.

**16.** A plasma processing apparatus according to claim 13, wherein said second insulating part is composed of a gas layer.

**17.** A plasma processing apparatus according to claim 13, wherein a lead-out path forming surface of said first insulating part is withdrawn from a plasmatizing space forming surface of said electrode structure.

**18.** A plasma processing apparatus according to claim 13, wherein said first insulating part has a corner formed between said surface directed to said electrode structure and said lead-out path forming surface of said first insulating part and a corner formed between said lead-out path forming surface and said surface directed to said conductive member, and at least the former corner is chamfered.

**19.** A plasma processing apparatus according to claim 13, wherein said corner formed between said surface directed to said electrode structure and said lead-out path forming surface of said first insulating part and said corner formed between said lead-out path forming surface and said surface directed to said conductive member are both chamfered, and the former corner is more heavily chambered than the latter corner.

**20.** A plasma processing apparatus according to claim 13, wherein said corner formed between said lead-out path forming surface and said surface directed to said conductive member of said first insulating part is chamfered, said conductive member including an edge surface for forming a jet port connected to the downstream of said lead-out path, said jet port edge surface being located in a generally same position as the boundary between said surface directed to said conductive member and said chamfered part of said first insulating part or in a position withdrawn therefrom.

**21.** A plasma processing apparatus according to claim 13, wherein said conductive member includes a surface directed to said first insulating part, an edge surface for forming a jet port connected to the downstream of said lead-out path and a surface to be directed to said workpiece, a corner is formed between said surface directed to said first insulating part and said jet port edge surface and a corner is formed between said jet port edge surface and said surface to be directed to said workpiece, and at least the former corner is chamfered.

**22.** A plasma processing apparatus according to claim 13, wherein said conductive member includes an edge surface for forming a jet port connected to the downstream of said lead-out path, and said jet port edge surface is withdrawn from said plasmatizing space forming surface of said electrode structure or said lead-out path forming surface of said first insulating member.

**23.** A plasma processing apparatus according to claim 13, wherein said conductive member includes an edge surface for forming a jet port connected to the downstream of said lead-out path, and said jet port edge surface is protruded from said plasmatizing space forming surface of said electrode structure or said lead-out path forming surface of said first insulating part.

**24.** A plasma processing apparatus according to claim 13, wherein said pair of electrodes of said electrode structure has an elongate configuration extending in the direction orthogonal to the mutually opposing direction, said insulator and said conductive member are extended in the same direction as said electrodes and thus, said lead-out path and a jet port formed in said conductive member in such a manner as to be connected to the downstream end of said lead-out path are extended in the same direction as said electrodes, said jet port being open in the direction generally orthogonal to said mutually opposing direction and said extended direction.

**25.** A plasma processing apparatus according to claim 24, wherein a spacer composed of an insulating material is sandwiched between the respective end parts on the same side in the longitudinal direction of said pair of electrodes, and said conductive member is formed in such a manner as to keep away from the boundary between said spacer and said electrodes.

**26.** A plasma processing apparatus according to claim 16, wherein a hole part is opened in said conductive member, said lead-out path of said first insulating part is arranged inside said hole part, a suction path including said hole part as a suction port is defined by said conductive member and said first insulating part, and said suction path is provided as a gas layer serving as said second insulating part.

27. A plasma processing apparatus according to claim 26, wherein one of said pair of electrodes of said electrode structure is coaxially annularly surrounded by the other electrode, thereby forming said plasmatizing space into an annular configuration.

28. An apparatus for carrying out plasma processing by plasmatizing a processing gas and jetting said plasmatized gas onto an object to be processed, said plasma processing apparatus comprising:

an electrode structure composed of a pair of electrodes for forming a plasmatizing space; and
a conductive member arranged on the side to be directed to said object of said electrode structure through an insulator in a state that said conductive member is electrically grounded,
said conductive member including an edge surface for forming a jet port connected to the downstream of said plasmatizing space, said jet port edge surface being non-flush with said plasmatizing space forming surface of said electrode.

29. A plasma processing apparatus according to claim 28, wherein said insulator includes an insulating member, said insulating member includes a surface for forming a lead-out path connected to the downstream of said plasmatizing space and connected to the upstream of said jet port, and said lead-out path forming surface is withdrawn from said plasmatizing space forming surface of said electrode structure.

30. A plasma processing apparatus according to claim 29, wherein said insulating member includes a surface directed to said electrode structure, said lead-out path forming surface and a surface directed to a conductive member, a corner is formed between said surface directed to said electrode structure and said lead-out path forming surface and a corner is formed between said surface lead-out path forming surface and said surface directed to said conductive member, and at least the former corner is chamfered.

31. A plasma processing apparatus according to claim 28, wherein said insulator includes a gas layer.

32. A plasma processing apparatus according to claim 28, wherein said conductive member includes a surface directed to said insulator, said jet port edge surface and said surface to be directed to said object, a corner is formed between said surface directed to said insulator and said jet port edge surface and a corner is formed between said jet port edge surface and said surface to be directed to said object, and at least the former corner is chamfered.

33. An apparatus for carrying out plasma processing by plasmatizing a processing gas and jetting the plasmatized gas onto an object to be processed, said plasma processing apparatus comprising:

an electrode structure composed of a pair of electrodes for forming said plasmatizing space; and
a conductive member arranged on the side to be directed to said object of said electrode structure through an insulator in a state that said conductive member is electrically grounded,
said conductive member includes an edge surface for forming a jet port connected to the downstream of said plasmatizing space, and said jet port edge surface is withdrawn from said plasmatizing space forming surface of said electrode.

34. An apparatus for carrying out plasma processing by plasmatizing a processing gas and jetting the plasmatized gas onto an object to be processed, said plasma processing apparatus comprising:

an electrode structure composed of a pair of electrodes for forming said plasmatizing space; and
a conductive member arranged on the side to be directed to said object of said electrode structure through an insulator in a state that said conductive member is electrically grounded,
said conductive member including an edge surface for forming a jet port connected to the downstream of said plasmatizing space and said jet port edge surface being protruded from said plasmatizing space forming surface of said electrode.

35. An apparatus for carrying out plasma processing by plasmatizing a processing gas and jetting the plasmatized gas onto an object to be processed, said plasma processing apparatus comprising:

an electrode structure composed of a pair of electrodes for forming said plasmatizing space; and
a conductive member arranged on the side to be directed to said object of said electrode structure through an insulator including a solid insulating member in a state that said conductive member is electrically grounded,

said insulating member including a surface for forming a lead-out path connected to the downstream of said plasmatizing space, said conductive member including an edge surface for forming a jet port connected to the downstream of said lead-out path, and said jet port edge surface being non-flush with said lead-out path forming surface of said insulating member.

36. A plasma processing apparatus according to claim 35, wherein said lead-out path forming surface of said insulating member is withdrawn from said plasmatizing space forming surface of said electrode structure.

37. A plasma processing apparatus according to claim 35, wherein said insulating member including a surface directed to said electrode structure, said lead-out path forming surface and a surface directed to said conductive member, a corner is formed between said surface directed to said electrode structure and said lead-out path forming surface and a corner is formed between said lead-out path forming surface and said surface directed to said conductive member, and at least the former corner is chamfered.

38. A plasma processing apparatus according to claim 35, wherein said insulator includes a gas layer.

39. A plasma processing apparatus according to claim 36, wherein said conductive member includes a surface directed to said insulator, said jet port edge surface and said surface to be directed to said object, a corner is formed between said surface directed to said insulator and said jet port edge surface and a corner is formed between said jet port edge surface and said surface to be directed to said object, and at least the former corner is chamfered.

40. An apparatus for carrying out plasma processing by plasmatizing a processing gas and jetting the plasmatized gas onto an object to be processed, said plasma processing apparatus comprising:

an electrode structure composed of a pair of electrodes for forming said plasmatizing space; and
a conductive member arranged on the side to be directed to said object of said electrode structure through an insulator including a solid insulating member in a state that said conductive member is electrically grounded.

said insulating member including a surface for forming a lead-out path connected to the downstream of said plasmatizing space, said conductive member including an edge surface for forming a jet port connected to the downstream of said lead-out path, and said jet port edge surface being withdrawn from said lead-out path forming surface of said insulating member.

41. A plasma processing apparatus according to claim 40, wherein a corner formed between said lead-out path forming surface and said surface directed to said conductive member of said insulating member is chambered, and said jet port edge surface of said conductive member is located in the generally same position as the boundary between said surface directed to said conductive member and said chamfered part of said insulating member or in a position withdrawn therefrom.

42. An apparatus for carrying out plasma processing by plasmatizing a processing gas and jetting the plasmatized gas onto an object to be processed, said plasma processing apparatus comprising:

an electrode structure composed of a pair of electrodes for forming a plasmatizing space; and
a conductive member arranged on the side to be directed to said object of said electrode structure through an insulator including a solid insulating member in a state that said conductive member is electrically grounded, said insulating member including a surface for forming a lead-out path connected to the downstream of said plasmatizing space, said conductive member including an edge surface for forming a jet port connected to the downstream of said lead-out path, and said jet port edge surface being protruded from said lead-out path forming surface of said insulating member.

**Amended claims under Art. 19.1 PCT**

1. AMENDED)
A method for manufacturing a plasma processing apparatus for processing the surface of a workpiece, by jetting a plasmatized gas passed through a plasmatizing space onto a workpiece arranged outside the plasmatizing space, said apparatus comprising an electrode for forming said plasmatizing space; an electrically grounded conductive member being arranged in such a manner as to shield the side of said electrode which is to be directed to said workpiece; and an insulating member composed of an insulator being interposed between said electrode and said conductive member,

said method being **characterized in that** it comprises the step of:

establishing the dielectric constant and the thickness of said insulating member such that the voltage applied between said insulating member and said conductive member becomes smaller than the sparking voltage in a range where variation of the separation distance between said insulating member and said conductive member, i.e., variation of the thickness of a gap formed between said insulating member and said conductive member can be anticipated.

**2.** AMENDED)
A method for manufacturing a plasma processing apparatus, for processing the surface of a workpiece, by jetting a plasmatized gas passed through a plasmatizing space onto a workpiece arranged outside the plasmatizing space, said apparatus comprising an electrode for forming said plasmatizing space; an electrically grounded conductive member being arranged in such a manner as to shield the side of said electrode which is to be directed to said workpiece; and an insulating member composed of an insulator being interposed between said electrode and said conductive member,

said method being **characterized in that** it comprises the steps of:

carrying out an experiment for measuring said sparking voltage;
obtaining a relation of said sparking voltage with respect to the separation distance, i.e., the thickness of a gap formed between said insulating member and said conductive member based on the measured data in which a spark occurs at a lower level than the average; and
establishing the dielectric constant and the thickness of said insulating member such that the voltage applied between said insulating member and said conductive member becomes smaller than the sparking voltage based on said measured data in a range where variation of the thickness of a gap formed between said insulating member and said conductive member can be anticipated.

**3.** AMENDED)
A method for manufacturing said plasma processing apparatus according to claim 1, said apparatus further comprising a solid dielectric disposed at a plasmatizing space forming surface and said surface to be directed to said workpiece of said electrode, said insulating member being laid on the said workpiece side of said solid dielectric, wherein the step of establishing includes taking the dielectric constant and the thickness of said solid dielectric on said workpiece side into consideration.

**4.** AMENDED)
A method for manufacturing a plasma processing apparatus for processing the surface of a workpiece, by jetting a plasmatized gas passed through a plasmatizing space onto a workpiece arranged outside the plasmatizing space, said apparatus comprising an electrode for forming said plasmatizing space; an electrically grounded conductive member being arranged in such a manner as to shield the side of said electrode which is to be directed to said workpiece, a gas layer as an insulator being formed between said electrode and said conductive member,

said method being **characterized in that** it comprises the step of:

establishing the thickness of said gas layer such that the voltage applied between said electrode and said conductive member becomes smaller than the sparking voltage in a range where variation of the thickness of said gas layer can be anticipated.

**5.** AMENDED)
A method for manufacturing a plasma processing apparatus for processing the surface of a workpiece, by jetting a plasmatized gas passed through a plasmatizing space onto a workpiece arranged outside the plasmatizing space, said apparatus comprising an electrode for forming said plasmatizing space; a solid dielectric being disposed at a plasmatizing space forming surface and said surface to be directed to said workpiece of said electrode; and an electrically grounded conductive member being arranged in such a manner as to shield the side of said electrode which is to be directed to said workpiece, a gas layer as an insulator being formed between said solid dielectric on said workpiece side of said electrode and said conductive member,

said method being **characterized in that** it comprises the step of:

establishing the thickness of said gas layer such that the voltage applied between said solid dielectric on said workpiece side and said conductive member becomes smaller than the sparking voltage in a range where variation of the thickness of said gas layer can be anticipated.

**6.** AMENDED)
A method for manufacturing said plasma processing apparatus according to claim 5, wherein the step of establishing includes carrying out an experiment for measuring said sparking voltage, obtaining a relation of said sparking voltage with respect to the thickness of said gas layer based on the measured data in which a spark occurs at a lower level than the average, and establishing the thickness of said gas layer such that the voltage applied to said gas layer becomes smaller than the sparking voltage based on said measured data in a range where variation of the thickness of said gas layer can be anticipated.

**7.** AMENDED)
A plasma processing apparatus manufactured by said manufacturing method according to claim 1, wherein the thickness of said gap formed between said insulating member and said conductive member is zero.

**8.** AMENDED)
A plasma processing apparatus manufactured by said manufacturing method according to claim 1, wherein a gap is formed between said insulating member and said conductive member.

**9.** AMENDED)
A plasma processing apparatus manufactured by said manufacturing method according to claim 1, wherein said conductive member includes a surface directed to said insulating member, an edge surface for forming a jet port connected to said plasmatizing space and a surface to be directed to said workpiece, a corner is formed between said surface directed to said insulating member and an edge surface of said jet port and a corner is formed between said edge surface of said jet port and said surface to be directed to said workpiece, and at least the former corner is chamfered.

**10.** AMENDED)
A plasma processing apparatus manufactured by said manufacturing method according to claim 1, wherein said conductive member includes a surface directed to said insulating member, an edge surface for forming a jet port connected to said plasmatizing space and a surface to be directed to said workpiece, and said jet port edge surface is rounded toward said surface directed to said insulator and said surface to be directed to said workpiece, respectively.

**11.** AMENDED)
A plasma processing apparatus manufactured by said manufacturing method according to claim 1, wherein said insulating member includes a surface directed to said electrode, said lead-out path forming surface connected to said plasmatizing space and a surface directed to said conductive member, a corner is formed between said surface directed to said electrode and said lead-out path forming surface and a corner is formed between said surface lead-out path forming surface and said surface directed to said conductive member, and at least the former corner is chamfered.

**12.** AMENDED)
A plasma processing apparatus manufactured by said manufacturing method according to claim 1, wherein said insulating member includes a surface directed to said electrode, said lead-out path forming surface connected to said plasmatizing space and a surface directed to said conductive member, said corner formed between said surface directed to said electrode and said lead-out path forming surface of said first insulating part and said corner formed between said lead-out path forming surface and said surface directed to said conductive member are both chamfered, and the former corner is more heavily chambered than the latter corner.

**13.** AMENDED)
An apparatus for carrying out plasma processing by plasmatizing a processing gas and jetting said plasmatized gas onto an object to be processed, said plasma processing apparatus being **characterized by** comprising:

an electrode structure composed of a pair of electrodes for forming said plasmatizing space;
an electrically grounded conductive member arranged in such a manner as to shield the side to be directed to said object of said electrode structure; and
an insulating means interposed between said electrode structure and said conductive member and adapted to insulating them one from the other,
said insulating means being divided into a first insulating part including a surface for forming a processing gas lead-out path connected to the downstream of said plasmatizing space, and a second insulating part separately arranged on the reverse side of said lead-out path side of said first insulating path and being separatable one from the other.

**14.** A plasma processing apparatus according to claim 13, wherein said first insulating part is composed of an insulating material having a higher plasma resistance property than said second insulating part.

**15.** A plasma processing apparatus according to claim 13, wherein said first insulating part is composed of an insulating material having a plasma resistance property.

**16.** A plasma processing apparatus according to claim 13, wherein said second insulating part is composed of a gas layer.

**17.** A plasma processing apparatus according to claim 13, wherein a lead-out path forming surface of said first insulating part is withdrawn from a plasmatizing space forming surface of said electrode structure.

**18.** A plasma processing apparatus according to claim 13, wherein said first insulating part has a corner being formed between said surface directed to said electrode structure and said lead-out path forming surface of said first insulating part and a corner being formed between said lead-out path forming surface and said surface directed to said conductive member, and at least the former corner is chamfered.

**19.** A plasma processing apparatus according to claim 13, wherein said corner formed between said surface directed to said electrode structure and said lead-out path forming surface of said first insulating part and said corner formed between said lead-out path forming surface and said surface directed to said conductive member are both chamfered, and the former corner is more heavily chambered than the latter corner.

**20.** A plasma processing apparatus according to claim 13, wherein said corner formed between said lead-out path forming surface and said surface directed to said conductive member of said first insulating part is chamfered, said conductive member including an edge surface for forming a jet port connected to the downstream of said lead-out path, said jet port edge surface being located in a generally same position as the boundary between said surface directed to said conductive member and said chamfered part of said first insulating part or in a position withdrawn therefrom.

**21.** A plasma processing apparatus according to claim 13, wherein said conductive member includes a surface directed to said first insulating part, an edge surface for forming a jet port connected to the downstream of said lead-out path and a surface to be directed to said workpiece, a corner is formed between said surface directed to said first insulating part and said jet port edge surface and a corner is formed between said jet port edge surface and said surface to be directed to said workpiece, and at least the former corner is chamfered.

**22.** A plasma processing apparatus according to claim 13, wherein said conductive member includes an edge surface for forming a jet port connected to the downstream of said lead-out path, and said jet port edge surface is withdrawn from said plasmatizing space forming surface of said electrode structure or said lead-out path forming surface of said first insulating member.

**23.** A plasma processing apparatus according to claim 13, wherein said conductive member includes an edge surface for forming a jet port connected to the downstream of said lead-out path, and said jet port edge surface is protruded from said plasmatizing space forming surface of said electrode structure or said lead-out path forming surface of said first insulating part.

**24.** A plasma processing apparatus according to claim 13, wherein said pair of electrodes of said electrode structure has an elongate configuration extending in the direction orthogonal to the mutually opposing direction, said insulator and said conductive member are extended in the same direction as said electrodes and thus, said lead-out path and a jet port formed in said conductive member in such a manner as to be connected to the downstream end of said lead-out path are extended in the same direction as said electrodes, said jet port being open in the direction generally orthogonal to said mutually opposing direction and said extended direction.

**25.** A plasma processing apparatus according to claim 24, wherein a spacer composed of an insulating material is sandwiched between the respective end parts on the same side in the longitudinal direction of said pair of electrodes, and said conductive member is formed in such a manner as to keep away from the boundary between said spacer and said electrodes.

**26.** AMENDED)
A plasma processing apparatus according to claim 16, wherein a hole part is opened in said conductive member, said lead-out path of said first insulating part is arranged at the central part of said hole part, a suction path having a suction port served by a peripheral part of said hole part is defmed by said conductive member and said first insulating part, and said suction path is provided as a gas layer serving as said second insulating part.

**27.** A plasma processing apparatus according to claim 26, wherein one of said pair of electrodes of said electrode structure is coaxially annularly surrounded by the other electrode, thereby forming said plasmatizing space into an annular configuration.

**28.** DELETED)

**29.** DELETED)

**30.** DELETED)

**31.** DELETED)

**32.** DELETED)

**33.** DELETED) .

[Fig.1]

M

Processing Gas — 2

32    30a    31

3
Vpp

33
40
40b

40a    50a    $t_A$    $t_B$    d    W    51
5

[Fig.2]

31X

3
Vpp

49

40b

51X

[Fig.3]

[Fig.4]

[Fig.5]

[Fig.6]

[Fig.7]

Processing Gas 2

32    30a    31    3

Vpp

33

tA    d    ～40b～    5

50a    51    W

[Fig.8]

Processing Gas 2

32    33    30a    31    3

Vpp

～40b～    d    ～40b～    5

50a    51    W

[Fig.9]

[Fig.10]

[Fig.11]

[Fig.12]

[Fig.13]

[Fig.14]

[Fig.15]

[Fig.16]

[Fig.17]

30a

30

31

32

50

42S 51 41 50a   40a  41  42S
                         45

[Fig.18]

30

31        32

30a

33

50

33

51  42  41   41b  41b  40a
      45      50a

[Fig.19]

[Fig.20]

[Fig.21]

[Fig.22]

EP 1 631 128 A1

## INTERNATIONAL SEARCH REPORT

| International application No. |
|---|
| PCT/JP2004/006434 |

### A. CLASSIFICATION OF SUBJECT MATTER
Int.Cl⁷ H05H1/24, H01L21/3065, H01L21/205

According to International Patent Classification (IPC) or to both national classification and IPC

### B. FIELDS SEARCHED

Minimum documentation searched (classification system followed by classification symbols)
Int.Cl⁷ H05H1/24, H01L21/3065, H01L21/205, C23C16/50, B01J19/08, C08J7/00

Documentation searched other than minimum documentation to the extent that such documents are included in the fields searched
| | | | |
|---|---|---|---|
| Jitsuyo Shinan Koho | 1940–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2003-100646 A (Sekisui Chemical Co., Ltd.), 04 April, 2003 (04.04.03), Claims 1 to 3; Par. Nos. [0005], [0014] to [0022], [0038]; Figs. 1 to 2 (Family: none) | 1,5-8,11,13, 16,24. |
| Y | JP 2003-93869 A (Sekisui Chemical Co., Ltd.), 02 April, 2003 (02.04.03), Par. Nos. [0016], [0017]; Figs. 1 to 2 (Family: none) | 1-42. |
| Y | JP 11-106531 A (Sekisui Chemical Co., Ltd.), 20 April, 1999 (20.04.99), Par. Nos. [0021] to [0024]; Figs. 1 to 6 (Family: none) | 1-42 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 23 August, 2004 (23.08.04) | 07 September, 2004 (07.09.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| International application No. |
| --- |
| PCT/JP2004/006434 |

C (Continuation).  DOCUMENTS CONSIDERED TO BE RELEVANT

| Category* | Citation of document, with indication, where appropriate, of the relevant passages | Relevant to claim No. |
| --- | --- | --- |
| Y | JP 2002-158219 A  (Sekisui Chemical Co., Ltd.), 31 May, 2002 (31.05.02), Par. Nos. [0024] to [0029]; Figs. 1 to 2 (Family: none) | 1-42 |
| Y | JP 9-213497 A  (Seiko Epson Corp.), 15 August, 1997 (15.08.97), Par. Nos. [0051], [0053], [0059] to [0061]; Figs. 1 to 6 & TW 498418 B | 1-42 |

Form PCT/ISA/210 (continuation of second sheet) (January 2004)